# EUROPEAN PATENT APPLICATION

(11) **EP 2 461 369 A1**
(43) Date of publication of application: **06.06.2012**
(21) Application number: 10804094.0
(22) Date of filing: 26.07.2010
(51) Int. Cl.: H01L 31/042, B32B 9/00, B32B 27/36

(54) **SOLAR CELL MODULE**

(30) Priority: 30.07.2009 JP 2009178298
(71) Applicant: Mitsubishi Plastics, Inc., Tokyo 103-0021 (JP)
(72) Inventor: OKAWARA, Chiharu, Ushiku-shi Ibaraki 300-1201 (JP); YOSHIDA, Shigenobu, Ushiku-shi Ibaraki 300-1201 (JP); HACHISUKA, Tooru, Ushiku-shi Ibaraki 300-1201 (JP); WATANABE, Hiromu, Yokohama-shi Kanagawa 227-8502 (JP)
(74) Representative: Siegert, Georg
(86) International application number: PCT/JP2010/004741
(87) International publication number: WO 2011/013341

(57) **Abstract**

A solar cell module including a thin-film solar cell element protected with a novel gas barrier film is provided. The solar cell module includes a laminate obtained by laminating a gas barrier film on a layer including at least a solar cell element. The gas barrier film is obtained by laminating at least a substrate film, weather-resistant coating layer, and inorganic thin film layer. The weather-resistant coating layer is made of at least one of (a) a material obtained by crosslinking modified polyvinyl alcohol, (b) a material obtained by crosslinking polycaprolactone polyol and/or a material obtained by crosslinking polycarbonate polyol, and (c) an acrylic polymer having at least one group selected from the group consisting of an UV-stabilizing group, UV-absorbing group, and cycloalkyl group. The solar cell element is a thin-film solar cell element.

## Description

### TECHNICAL FIELD

The present invention relates to a solar cell module.

### BACKGROUND ART

A technique that covers a solar cell with a given film in order to protect the solar cell from the environment has conventionally been proposed. However, a solar cell element is particularly easily deteriorated by water and oxygen. Therefore, demands have arisen for protecting a solar cell module with a film having a higher protection performance in order to further increase the environmental resistance and prolong the life of the solar cell module.

Presently, a thin-film solar cell that is light in weight, hardly cracks, and can be used on a curved surface is particularly attracting attention. When decreasing the film thickness of a solar cell, it is important to decrease the film thickness of a solar cell element, particularly, decrease the film thickness of a power generating layer in the solar cell element. Since it is difficult to decrease the film thickness of conventional single-crystal silicon, amorphous silicon, a compound semiconductor including a CIGS semiconductor, an organic semiconductor, or the like is preferably used as a light absorbing layer in the power generating layer. However, these semiconductors, particularly, a compound semiconductor and organic semiconductor are especially weak against water, oxygen, heat, and an organic substance generated from a constituent member. Accordingly, it is necessary to maximally eliminate these factors in order to prolong the life.

NPL1 has disclosed a method of preventing deterioration of a CIGS solar cell element at a high temperature and high humidity by using, as a barrier coating, an alternate laminate of acrylic polymer films and thin inorganic oxide films obtained by sputtering.

### CITATION LIST

### NON PATENT LITERATURE

NPL1: Olsen, L.; Kundu, S.; Bonham, C.; Gross, M. In Barrier coatings for CIGSS and CdTe cells, Photovoltaic Specialists Conference, 2005. Conference Record of the Thirty-first IEEE, 2005; pp 327-330

### SUMMARY OF INVENTION

### TECHNICAL PROBLEM

Unfortunately, a gas barrier film most suitable in respect to the weight, strength, deformability, and the like changes in accordance with the application of a solar cell module. Developing a solar cell module including a gas barrier film having an environmental resistance different from that of the barrier coating disclosed in NPL1 extends the range of selection of a solar cell module, and particularly extends the range of selection of a thin-film solar cell module.

The present invention provides a solar cell module including a thin-film solar cell element protected with a novel gas barrier film.

### SOLUTION TO PROBLEM

To achieve the object of the present invention, a solar cell module of the present invention includes, for example, the following configuration. That is,
a solar cell module including a laminate obtained by laminating a gas barrier film on a layer including at least a solar cell element is **characterized in that**
the gas barrier film is obtained by laminating at least a substrate film, weather-resistant coating layer, and inorganic thin film layer,
the weather-resistant coating layer is made of at least one of (a) a material obtained by crosslinking modified polyvinyl alcohol, (b) a material obtained by crosslinking polycaprolactone polyol and/or a material obtained by crosslinking polycarbonate polyol, and (c) an acrylic polymer having at least one group selected from the group consisting of an UV-stabilizing group, UV-absorbing group, and cycloalkyl group, and
the solar cell element is a thin film.

### ADVANTAGEOUS EFFECTS OF INVENTION

A solar cell module including a thin-film solar cell element protected with a novel gas barrier film is provided.

Other features and advantages of the present invention will be apparent from the following explanation taken in conjunction with the accompanying drawings. Note that the same reference numerals denote the same or similar parts in the accompanying drawings.

### BRIEF DESCRIPTION OF DRAWINGS

The accompanying drawings, which are incorporated in and constitute a part of the specification, illustrate embodiments of the invention and, together with the description, serve to explain the principles of the invention.
Fig. 1 is a view for explaining an example of a solar cell element according to the present invention;
Fig. 2 is a view for explaining the energy conversion characteristics of solar cell modules of different examples;
Fig. 3 is a view for explaining the changes in JV characteristics with time of a solar cell module of Example 1;
Fig. 4 is a view for explaining the changes in JV characteristics with time of a solar cell module of Comparative Example 1;
Fig. 5 is a view for explaining the arrangement of solar cell modules according to Examples E1 and E2;
Fig. 6 is a view for explaining the arrangement of a solar cell module according to Comparative Example E1; and
Fig. 7 is a view for explaining the arrangement of a solar cell module according to Comparative Example E2.

### DESCRIPTION OF EMBODIMENTS

The present invention will be explained in detail below by way of its embodiments, examples, and the like. However, the present invention is not limited to the following embodiments, examples, and the like, and arbitrary changes can be made when the present invention is practiced without departing from the spirit and scope of the invention.

A solar cell module of the present invention can be any solar cell module as long as it includes a laminate obtained by laminating a gas barrier film to be explained in detail below, on a layer including an arbitrary solar cell element. That is, the solar cell module of the present invention need only include at least solar cell element (A) and gas barrier film (B). In the present invention, gas barrier film (B) is placed so as to protect solar cell element (A) from gases such as water vapor and oxygen. The method of placement is not limited, so it is possible to use two or more gas barrier films, and encapsulate the solar cell element between them. It is also possible to sandwich a layer including the solar cell element between the gas barrier film and another element such as a glass substrate having a gas barrier function.

When the gas barrier film has a structure formed by laminating a substrate film, weather-resistant coating layer, and inorganic thin film layer in this order, solar cell element (A) and gas barrier film (B) can be arranged such that the solar cell element is positioned on the substrate film side of the gas barrier film. Solar cell element (A) and gas barrier film (B) can also be arranged such that the solar cell element is positioned on the inorganic thin film layer side of the gas barrier film. However, by arranging the solar cell element, substrate film, weather-resistant coating layer, and inorganic thin film layer in this order, the substrate film itself in gas barrier film (B) can be protected against water vapor and the like by the inorganic thin film layer. Furthermore, a plurality of gas barrier films can be used. This makes it possible to more strongly protect the solar cell element, particularly, a solar cell thin film element against water vapor and the like. The substrate film, weather-resistant coating layer, and inorganic thin film layer will be explained in detail later.

### [A Solar Cell Element]

In the present invention, it is possible to use, for example, a thin film polycrystalline silicon solar cell element, amorphous silicon-based solar cell element, compound semiconductor-based solar cell element, and organic solar cell element, as the solar cell element. A compound semiconductor-based solar cell element and organic thin-film solar cell element (to be also simply referred to as solar cell elements in this specification) will be described below as examples, but other solar cell elements are not excluded as long as the present invention is not significantly spoiled. Also, the compound semiconductor-based solar cell element and organic thin-film solar cell element are not limited to the examples to be explained below.

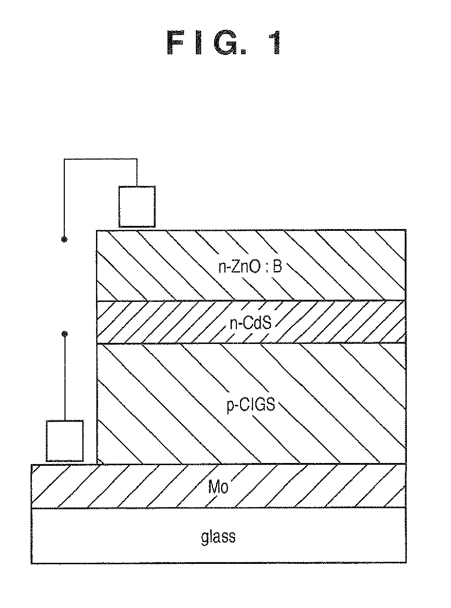

The solar cell element in the present invention is a thin-film solar cell element. "The solar cell element is a thin film" more specifically means that a portion that receives light and generates electricity in the solar cell element is a thin film. Fig. 1 shows the structure of a CIGS-based solar cell element as an example. In this example shown in Fig. 1, a ZnO (zinc oxide) layer, CdS (cadmium sulfide) layer, CIGS layer, and Mo (molybdenum) layer form the portion that receives light and generates electricity, and this portion is called a power generating layer. In the present invention, the thickness of the power generating layer is preferably 100 µm or less, more preferably 20 µm or less, further preferably 10 µm or less, and particularly preferably 5 µm or less. As the thickness of the power generating layer decreases, the thickness of the whole solar cell element can be decreased. Also, in the present invention, the thickness of the power generating layer is preferably 0.1 µm or more, more preferably 0.5 µm or more, further preferably 1 µm or more, and particularly preferably 3.5 µm or more, in order to increase the durability of the power generating layer.

To thin the power generating layer, it is also important to thin a light absorbing layer as a portion that absorbs light. In the example shown in Fig. 1, the CIGS layer is the light absorbing layer. In the present invention, the thickness of the light absorbing layer is preferably 50 µm or less, more preferably 10 µm or less, further preferably 5 µm or less, and particularly preferably 2.5 µm or less. Also, in the present invention, the thickness of the light absorbing layer is preferably 0.1 µm or more, more preferably 0.5 µm or more, further preferably 1 µm or more, and particularly preferably 2 µm or more, in order to increase the durability of the light absorbing layer.

### [A-1 Compound Semiconductor-Based Solar Cell Element]

First, the compound semiconductor-based solar cell element suitably used in the present invention will be explained. As the compound semiconductor-based solar cell element, it is possible to favorably use chalcogenide-based solar cell elements containing chalcogen elements such as S, Se, and Te. Among other solar cell elements, a group I-III-VI₂ semiconductor-based (chalcopyrite-based) solar cell element is favorable, and a group Cu-III-VI₂ semiconductor-based solar cell element using Cu as a group I element is particularly favorable because this solar cell element has a photoelectric conversion efficiency theoretically higher than that of an Si crystal type solar cell.

The group Cu-III-VI₂ semiconductor-based solar cell element is a solar cell element containing a group Cu-III-VI₂ semiconductor as a constituent material. The group Cu-III-VI₂ semiconductor is a semiconductor made of a compound containing Cu, a group III element, and a group VI element at a ratio of 1 _{:} 1 _{:} 2. Examples are CuInSe₂, CuGaSe₂, Cu(In₁₋ₓGaₓ)Se₂, CuInS₂, CuGaS₂, Cu(In₁₋ₓGaₓ)S₂, CuInTe₂, CuGaTe₂, and Cu(In₁₋ₓGaₓ)Te_{2.} This semiconductor may also be a mixture of two or more of these compounds. Among other solar cell elements, a CIS-based solar cell element and CIGS-based solar cell element are particularly favorable.

The CIS-based solar cell element is a solar cell containing a CIS-based semiconductor as a constituent material. The CIS-based semiconductor is CuIn(Se_{1-y}S_{y})₂ where y represents a number from 0 (inclusive) to 1 (inclusive). That is, the CIS-based semiconductor is CuInSe₂, CuInS₂, or a mixture thereof. The use of S instead of Se is favorable because the safety increases.

The CIGS-based solar cell element is a solar cell containing a CIGS-based semiconductor as a constituent material. The CIGS-based semiconductor is Cu(In₁₋ₓGaₓ) (Se_{1-y}S_{y})₂ where x represents a number larger than 0 and smaller than 1, and y represents a number from 0 (inclusive) to 1 (inclusive). Cu(In₁₋ₓGaₓ)Se₂ is normally a crystal mixture of CuInSe₂ and CuGaSe₂. Note that x is normally larger than 0, preferably larger than 0.05, and more preferably larger than 0.1, and is normally smaller than 0.8, preferably smaller than 0.5, and more preferably smaller than 0.4.

The above-mentioned group Cu-III-VI₂ semiconductor normally functions as a p-type semiconductor. P- and n-type semiconductors will be explained below. In a semiconductor, carriers for transporting electric charge include two types of carriers, that is, electrons and holes, and carriers having a higher density are called majority carriers. The majority carriers are normally determined by the type of semiconductor or the doping state. Also, a semiconductor in which the majority carriers are electrons is called an n-type semiconductor, a semiconductor in which the majority carriers are holes is called a p-type semiconductor, and a semiconductor in which electrons and holes are balanced is called an i-type semiconductor.

Note that the p or n type is not absolutely determined by the type of semiconductor. For example, even when semiconductors of the same type are combined, one operates as a p-type semiconductor and the other operates as an n-type semiconductor in some cases, depending on the energy level (HOMO level, LUMO level, or Fermi level) or the doping state.

The degree of the semiconductor characteristic of a semiconductor is normally 10⁻⁷ cm²/Vs or more, and preferably 10⁻⁵ cm²/Vs or more, as the value of the carrier mobility. The electrical conductivity is defined by carrier mobility x carrier density. Accordingly, a material having a carrier mobility to some extent can transport electric charge if carriers resulting from, for example, heat, doping, or injection from an electrode exist in the material. Note that the carrier mobility of a semiconductor is desirably as large as possible.

The above-mentioned group Cu-III-VI₂ semiconductor is normally contained in at least one of the layers forming the solar cell element, and the layer containing the semiconductor absorbs light and generates electricity in the solar cell element. A practical configuration of the compound semiconductor-based solar cell element will be explained below by taking examples. However, the compound semiconductor-based solar cell element according to the present invention is not limited to these examples to be explained below.

For example, the group Cu-III-VI₂ semiconductor-based solar cell element includes at least a light absorbing layer and buffer layer between a pair of electrodes. In the solar cell element having this configuration, the light absorbing layer absorbs light and generates electricity, and the generated electricity is extracted from the electrodes.

### <A-1-1 Electrode>

The electrode can be formed by using an arbitrary conductive material. Examples of the material of the electrode are metals such as platinum, gold, silver, aluminum, chromium, nickel, copper, titanium, magnesium, calcium, barium, and sodium, or alloys thereof; metal oxides such as indium oxide and tin oxide, or alloys (ITO) thereof; conductive polymers such as polyaniline, polypyrrol, polythiophene, and polyacetylene; materials obtained by adding dopants, for example, acids such as hydrochloric acid, sulfuric acid, and sulfonic acid, Lewis acids such as FeCl₃, halogen atoms such as iodine, and metal atoms such as sodium and potassium, to the above-mentioned conductive polymers; and conductive composite materials obtained by dispersing conductive particles such as metal particles, carbon black, fullerene, and carbon nanotubes in a matrix such as a polymer binder. Note that one type of these electrode materials can be used alone, and an arbitrary combination of two or more types thereof can also be used at an arbitrary ratio.

Furthermore, the solar cell element includes at least one pair of (two) electrodes. Of the pair of electrodes, at least an electrode on the light receiving surface side is preferably transparent so as to transmit light for power generation. However, this electrode need not always be transparent if no significant adverse effect is exerted on the power generation performance even though the electrode is not transparent, for example, if the area of the electrode is smaller than that of the power generating layer. Examples of the material of the transparent electrode are oxides such as ITO and indium zinc oxide (IZO); and a thin metal film. Although a practical range of the light transmittance is unlimited, the light transmittance is preferably 80% or more in order to increase the power generation efficiency of the solar cell element. Note that the light transmittance can be measured by an ordinary spectrophotometer.

### The electrode has a function of collecting holes and electrons generated by light absorption.

Accordingly, an electrode material suited to collecting holes and electrons is preferably used as the electrode. Examples of an electrode material suited for collecting holes are materials such as Au and ITO having high work functions. On the other hand, an example of an electrode material suited for collecting electrons is a material such as Al having a low work function.

Note that a method of forming the electrode is not limited. For example, the electrode can be formed by a dry process such as vacuum deposition or sputtering. It is also possible to form the electrode by a wet process using conductive ink or the like. In this process, a given material can be used as the conductive ink. For example, it is possible to use a conductive polymer or metal particle dispersion.

Furthermore, two or more electrode layers can be stacked, and the characteristics (for example, the electrical characteristics and wettability) can be improved by a surface treatment.

### <A-1-2 Light Absorbing Layer>

The light absorbing layer is a layer containing the above-described group Cu-III-VI₂ semiconductor. Since the group Cu-III-VI₂ semiconductor normally functions as a p-type semiconductor, it is possible to absorb light and generate electricity by forming the buffer layer (to be described later) by an n-type semiconductor. Note that the light absorbing layer can be formed by using one type of a group Cu-III-IV₂ semiconductor, or by using an arbitrary combination of two or more types of group Cu-III-IV₂ semiconductors at an arbitrary ratio. It is also possible to combine a CIS-based semiconductor and CIGS-based semiconductor.

The light absorbing layer is normally formed by using only the group Cu-III-IV₂ semiconductor, but can also contain another component as long as the effect of the present invention is not significantly spoiled. An example is an additive such as Ag. Note that the light absorbing layer can contain one type of another component, or an arbitrary combination of two or more types of other components at an arbitrary ratio.

A method of forming the light absorbing layer is not limited. For example, the light absorbing layer can be formed by vacuum deposition or sputtering. Furthermore, although only one light absorbing layer is normally formed, two or more light absorbing layers may also be stacked.

### [A-1-3 Buffer Layer]

The buffer layer is a layer stacked in contact with the light absorbing layer. The buffer layer is made of an n-type semiconductor when the light absorbing layer contains a p-type semiconductor, and made of a p-type semiconductor when the light absorbing layer contains an n-type semiconductor. Since the group Cu-III-VI₂ semiconductor is normally a p-type semiconductor, the buffer layer is formed by an n-type semiconductor in the group Cu-III-VI₂ semiconductor-based solar cell element.

Practical examples of the semiconductor forming the buffer layer are CdS, Zn₁₋ₓMgₓO (0 < x < 0.8), ZnS(O, OH), and InS. CuInS₂ described above can also be formed as an n-type semiconductor layer by using a composition shifted from the stoichiometric ratio by changing the formation conditions, so it is also possible to use this n-type semiconductor layer as the buffer layer. Note that the buffer layer can be formed by using one type of a semiconductor, or by using an arbitrary combination of two or more types of semiconductors at an arbitrary ratio.

A method of forming the buffer layer is not limited. For example, the buffer layer can be formed by vacuum deposition or sputtering. Furthermore, although only one buffer layer is normally formed, two or more buffer layers may also be stacked.

### [A-2 Organic Thin-film Solar Cell Element]

Next, the organic thin-film solar cell element suitably used in the present invention will be explained. The organic thin-film solar cell element includes at least an organic semiconductor layer formed between a pair of electrodes and containing an organic semiconductor. This organic semiconductor layer absorbs light and generates electric power, and the generated electric power is extracted from the electrodes.

### [A-2-1 Organic Semiconductor Layer]

The organic semiconductor layer can be formed by an arbitrary organic semiconductor. Organic semiconductors can be classified into p- and n-type semiconductors in accordance with the semiconductor characteristics. Examples of the p-type semiconductor are porphyrin compounds such as tetrabenzoporphyrin, tetrabenzo copper porphyrin, and tetrabenzo zinc porphyrin; phthalocyanine compounds such as phthalocyanine, copper phthalocyanine, and zinc phthalocyanine; naphthalocyanine compounds; polyacenes such as tetracene and pentacene; oligothiophenes such as sexithiophene, and derivatives containing these compounds as skeletons. Other examples are polymers such as polythiophene including poly (3-alkylthiophene), polyfluorene, polyphenylene vinylene, polytriarylamine, polyacetylene, polyaniline, and polypyrrol.

Examples of the n-type semiconductor are fullerene (C60, C70, and C76): octaazaporphyrin; perfluoro forms of the above-mentioned p-type semiconductors; aromatic carboxylic acid anhydrides and their imides such as naphthalenetetracarboxylic acid anhydride, naphthalenetetracarboxylic acid diimide, perylenetetracarboxylic acid anhydride, and perylenetetracarboxylic acid diimide; and derivatives containing these compounds as skeletons.

A practical configuration of the organic semiconductor layer is arbitrary, provided that at least the p- and n-type semiconductors are contained. The organic semiconductor layer can be either a single-layered film or a stacked film including two or more layers. For example, the n- and p-type semiconductors can be contained in different films or in the same film. Also, it is possible to use one type of each of the n-and p-type semiconductors, and use an arbitrary combination of two or more types of each of n- and p-type semiconductors at an arbitrary ratio.

Practical configuration examples of the organic semiconductor layer are a bulk heterojunction type structure including a layer (i-layer) in which the p- and n-type semiconductors are phase-separated, a stacked type (hetero p-n junction type) structure in which a layer (p-layer) containing the p-type semiconductor and a layer (n-layer) containing the n-type semiconductor have an interface, a Schottky type structure, and combinations of these structures. Among other structures, the bulk heterojunction type structure and a combination (p-i-n junction type structure) of the bulk heterojunction type structure and stacked type structure are favorable because high performance can be obtained.

Although the thickness of each of the p-, i-, and n-layers of the organic semiconductor layer is not limited, the thickness is normally 3 nm or more, and preferably 10 nm or more, and is normally 200 nm or less, and preferably 100 nm or less. When the layer thickness is increased, the uniformity of the film increases. When the layer thickness is decreased, the transmittance increases, and the series resistance decreases.

### [A-2-2 Electrode]

The electrode can be formed by an arbitrary conductive material. Examples of the electrode are metals such as platinum, gold, silver, aluminum, chromium, nickel, copper, titanium, magnesium, calcium, barium, and sodium, or alloys thereof; metal oxides such as indium oxide and tin oxide, or alloys (ITO) thereof; conductive polymers such as polyaniline, polypyrrol, polythiophene, and polyacetylene; materials obtained by adding dopants, for example, acids such as hydrochloric acid, sulfuric acid, and sulfonic acid, Lewis acids such as FeCl₃, halogen atoms such as iodine, and metal atoms such as sodium and potassium, to the above-mentioned conductive polymers; and conductive composite materials obtained by dispersing conductive particles such as metal particles, carbon black, fullerene, and carbon nanotubes in a matrix such as a polymer binder. Among other materials, materials such as Au and ITO having deep work functions are favorable as an electrode for collecting holes. On the other hand, a material such as Al having a shallow work function is favorable as an electrode for collecting electrons. By thus optimizing the work functions, holes and electrons generated by light absorption are well collected.

Of the pair of electrodes, at least an electrode on the light receiving surface side preferably has light transmittance for power generation. However, this electrode need not always be transparent if no significant adverse effect is exerted on the power generation performance even though the electrode is not transparent, for example, if the area of the electrode is smaller than that of the power generating layer. Examples of the material of the transparent electrode are oxides such as ITO and indium zinc oxide (IZO); and a thin metal film. Although a practical range of the light transmittance is unlimited, the light transmittance is preferably 80% or more, except for a loss caused by partial reflection on the optical interface, in order to increase the power generation efficiency of the solar cell element.

Note that one type of these electrode materials can be used alone, and an arbitrary combination of two or more types thereof can also be used at an arbitrary ratio. Note also that a method of forming the electrode is not limited. For example, the electrode can be formed by a dry process such as vacuum deposition or sputtering. It is also possible to form the electrode by a wet process using conductive ink or the like. In this process, a given material can be used as the conductive ink. For example, it is possible to use a conductive polymer or metal particle dispersion.

Furthermore, two or more electrode layers can be stacked, and the characteristics (for example, the electrical characteristics and wettability) can be improved by a surface treatment.

### [A-2-3 Other Layers]

The organic solar cell element disclosed in the above-mentioned examples may also include other layers in addition to the above-described organic semiconductor layers and electrodes. Note that other layers can be formed in arbitrary positions as long as they do not interfere with power generation by the solar cell element. An example of other layers is a buffer layer.

The buffer layer is a layer formed on the electrode interface facing the organic semiconductor layer, in order to improve the electrical characteristics and the like. Examples are poly(ethylenedioxythiophene) : poly(styrenesulfonic acid) (PEDOT : PSS), molybdenum oxide, lithium fluoride, and 2,9dimethyl-4,7-diphenyl-1,10-phenanthroline.

### [B Gas Barrier Film]

Gas barrier film (B) of the present invention is a film for protecting the interior from the environment, particularly, at least one of water and oxygen, and includes at least a weather-resistant coating layer. As the weather-resistance coating layer, it is possible to use at least one of a. a material obtained by crosslinking modified polyvinyl alcohol, b. a material obtained by crosslinking polycaprolactone polyol and/or a material obtained by crosslinking polycarbonate polyol, and c. an acrylic polymer having at least one group selected from the group consisting of an UV-stabilizing group, UV-absorbing group, and cycloalkyl group. Each weather-resistant coating layer will be explained below.

### [B-1-1 Weather-Resistant Coating Layer Using Modified Polyvinyl Alcohol]

Modified polyvinyl alcohol can be used as a resin for forming the weather-resistant coating layer according to the present invention. Examples of the modified polyvinyl alcohol are resins obtained by modifying a hydroxyl group of polyvinyl alcohol into, for example, a silanol group, silyl group, amino group, ammonium group, alkyl group, isocyanate group, oxazoline group, methylol group, nitrile group, acetoacetyl group, cation group, carboxyl group, carbonyl group, sulfone group, phosphate group, acetal group, ketal group, carbonate ester group, and cyanoethyl group. Modification by acetoacetalization or butyralization is particularly favorable in respect of the water resistance at a high temperature and high humidity. Also, since a hydroxyl group remains in the modified polyvinyl alcohol, the water resistance can further be increased by crosslinking the residual hydroxyl group.

Polyvinyl butyral as a modified form obtained by above-mentioned butyralization can be formed by a well-known method. To achieve a high weather resistance and obtain a uniform coating layer by increasing the solvent solubility, however, polyvinyl butyral desirably has a degree of butyralization of preferably 50 to 80 mol%, and more preferably 60 to 75 mol%, and contains preferably 1 mol% or less, and more preferably 0.5 mol% or less of an isotactic triad type residual hydroxyl group. The weather resistance and solvent solubility of polyvinyl butyral depend on the butyralization degree, so the butyralization degree is desirably as high as possible. However, polyvinyl alcohol cannot be butyralized 100 mol%, and increasing the butyralization degree to the limit is disadvantageous in industrial productivity. Also, the solvent compatibility changes in accordance with the type of residual hydroxyl group, and the solubility to an organic solvent often decreases if the amount of isotactic triad type hydroxyl group is large.

Also, polyvinyl acetoacetal as a modified form obtained by above-mentioned acetoacetalization can be formed by a well-known method, and the degree of acetalization is desirably as high as possible in respect of the heat resistance. The acetalization degree is preferably 50 to 80 mol%, and more preferably 65 to 80 mol%. To obtain a polyvinyl acetoacetal resin having a narrow grain size distribution in order to increase the solvent solubility and deposit a uniform coating layer, it is desirable to mix an appropriate amount of aldehyde having a carbon number of 3 or more, and hold a deposited acetalized product at an appropriate temperature.

A crosslinking compound is not particularly limited as long as it is a compound or polymer having, per molecule, two or more functional groups that cause a crosslinking curing reaction, and it is possible to appropriately select one type or two or more types in accordance with the type of functional group of the above-mentioned polyvinyl alcohol. When crosslinking a hydroxyl group of the modified polyvinyl alcohol, examples of the crosslinking compound are, for example, compounds or polymers having a phenol group, epoxy group, melamine group, isocyanate group, and dialdehyde group. Compounds or polymers having an epoxy group, melamine group, and isocyanate group are favorable in respect of the crosslinking reactivity and pot life, and an isocyanate group is particularly favorable in respect of pot life control.

When the crosslinking functional group of the modified polyvinyl alcohol is a carboxyl group or its anhydride, examples are crosslinking compounds such as a polyisocyanate compound or its modified product, an aminoplast resin, and an epoxy resin. When the crosslinking functional group is an epoxy group, examples are crosslinking compounds containing amine, carboxylic acid, amide, and a compound such as N-methylolalkyl ether. When the crosslinking functional group is a hydroxyl group or amino group, examples are crosslinking compounds such as a polyisocyanate compound or its modified product, an epoxy resin, and an aminoplast resin. Among other compounds, a polyisocyanate compound and/or epoxy resin is favorable as a combination with a group having active hydrogen.
In the present invention, a combination of a hydroxyl group as the crosslinking functional group and an isocyanate compound as the crosslinking compound is desirable as a two-part reactive coating agent in respect of the reactivity of components, the weather resistance resulting from the reactivity, and the hardness and flexibility of the coating layer.

Polyisocyanate can be one of diisocyanate, a dimer (uretdione) of diisocyanate, and a trimer (isocyanurate, a triol adduct, or biuret) of diisocyanate, or a mixture of two or more types thereof. Examples of the diisocyanate component are 2,4-trilenediisocyanate, 2,6-trilenediisocyanate, p-phenylenediisocyanate, diphenylmethanediisocyanate, m-phenylenediisocyanate, hexamethylenediisocyanate, tetramethylenediisocyanate, 3,3'-dimethoxy-4,4'-biphenylenediisocyanate, 1,5-naphthalenediisocyanate, 2,6-naphthalenediisocyanate, 4,4`-diisocyanatediphenyl ether, 1,5-xylylenediisocyanate, 1,3-diisocyanatemethylcyclohexane, 1,4-diisocyanatemethylcyclohexane, 4,4'-diisocyanatecyclohexane, 4,4'-diisocyanatecyclohexylmethane, isophoronediisocyanate, dimer acid diisocyanate, and norbornenediisocyanate. Xylylenediisocyanate (XDI), isophoronediisocyanate (IPDI), and hexamethylenediisocyanate (HDI) are favorable in respect of the non-yellowing properties. Also, an isocyanurate form and biuret form of hexamethylenediisocyanate are favorable in respect of the fastness, gas barrier properties, and weather resistance.

The epoxy resin is not particularly limited as long as it is a compound having two or more epoxy groups in one molecule. Examples are sorbitol polyglycidyl ether, sorbitan polyglycidyl ether, polyglycerol polyglycidyl ether, pentaerythritol polyglycidyl ether, triglycidyl, tris(2-hydroxyethyl)isocyanurate, neopentylglycol diglycidyl ether, 1,6-hexandiol diglycidyl ether, ethyleneglycol diglycidyl ether, and a bisphenol type epoxy resin.

The use amount of the above-mentioned crosslinking compound is not particularly limited, and can properly be determined in accordance with, for example, the type of crosslinking compound. However, the reactive group ratio of the crosslinking group (for example, a hydroxyl group) of the modified polyvinyl alcohol to the crosslinking group of the crosslinking compound is desirably hydroxyl group : crosslinking group = 1 : 1 to 1 : 20 in respect of the intra-layer cohesive force and inter-layer adhesion, and more preferably 1 : 1 to 1 : 10. When the crosslinking group ratio falls within this range, the compound is advantageous in adhesion, high-temperature/high-humidity resistance, gas barrier properties, and blocking resistance. To accelerate the crosslinking reaction, it is possible to add, to the above-mentioned crosslinking compound, one type or two or more types of crosslinking catalysts such as salts, inorganic substances, organic substances, acidic substances, and alkaline substances. When using a polyisocyanate compound as the crosslinking compound, for example, one type or two or more types of well-known catalysts such as dibutyl tin dilaurate and tertiary amine are added. The crosslinking compound can also contain, for example, a silane-based coupling agent, titanium-based coupling agent, light screen, UV absorbent, stabilizer, lubricant, anti-blocking agent, and anti-oxidation agent, or it is possible to use copolymers of these additives and the above-mentioned resins.

### [B-1-2 Weather-Resistant Coating Layer Using At Least One of Polycaprolactone Polyol and Polycarbonate Polyol]

As the resin forming the weather-resistant coating layer according to the present invention, at least one of polycaprolactone polyol and polycarbonate polyol can be used. As a coating material, polyester polyol readily hydrolyzes, but polycaprolactone polyol has a water resistance higher than that of adipate polyester polyol, and a weather resistance and heat resistance higher than those of polyether polyol. Also, polycarbonate polyol are superior in heat resistance, humidity resistance, and weather resistance to polyester polyol and polyether polyol. On the other hand, polycaprolactone polyol and polycarbonate polyol are inferior in inter-layer adhesion to polyester polyol. However, the inter-layer adhesion can be improved by, for example, adjusting the degree of a surface treatment such as a corona treatment of the substrate film, forming a very thin coating film of an adhesive component such as a crosslinking agent, or increasing the mixing ratio of the crosslinking compound in the coating material. This can further increase the weather resistance of the coating layer.

### <Polycaprolactone Polyol>

Polycaprolactone polyol is manufactured by ring opening polymerization of ε-caprolactone in the presence of a catalyst using the following polyvalent alcohol as an initiator in accordance with a well-known method. As the polyvalent alcohol as a polymerization initiator of ε-caprolactone, it is possible to use aliphatic polyvalent alcohols such as ethylene glycol, diethylene glycol, 1,2-propylene glycol, dipropylene glycol, 1,3-butanediol, 1,4-butanediol, 1,6-hexanediol, neopentyl glycol, trimethylolpropane, glycerin, pentaerythritol, polytetramethylene ether glycol, and polymerized products or copolymerized products obtained by performing ring opening polymerization of ethylene oxide, propylene oxide, and butylene oxide by using these polyvalent alcohols as initiators; polyvalent alcohols having a cyclohexyl group, such as cyclohexanedimethanol, cyclohexanediol, hydrogen-added bisphenol A, and polymerized products or copolymerized products obtained by performing ring opening polymerization of ethylene oxide, propylene oxide, and butylene oxide by using these glycols as initiators; polyvalent alcohols having an aromatic group, such as bisphenol A, hydroquinone bis(2-hydroxyethylether), p-xylylene glycol, bis(β-hydroxyethyl)terephthalate, and polymerized products or copolymerized products obtained by adding ethylene oxide, propylene oxide, and butylene oxide by using these glycols as initiators; and polyvalent alcohols having various functional groups, for example, glycol having a carboxyl group such as dimethylol propionic acid and diphenolic acid, and glycol having tertiary amine such as N-methyldiethanolamine. Examples of commercially available products are "PLACCEL 200" series manufactured by DAICEL CHEMICAL and "TONE" series manufactured by Union Carbide.

### <Polycarbonate Polyol>

Polycarbonate polyol can be manufactured by a well-known method. As polycarbonate diol, it is possible to preferably use polycarbonate diol obtained by condensation polymerization by reacting diphenyl carbonate or phosgene with aliphatic diol having a carbon number of 2 to 12, such as 1,4-butanediol, 1,5-pentanediol, 1,6-hexanediol, 1,8-otanediol, or 1,10-decanediol, or a mixture thereof. In respect of the compatibility with an organic solvent or the crosslinking compound, it is desirable to use ether modified polycarbonate polyol which is obtained by reacting polyalkylene carbonate polyol having a number average molecular weight of 10,000 or less, preferably 500 to 5,000 with polyethylene glycol monoalkyl ether having a number average molecular weight of 5,000 or less, and in which the repetitive structure unit has - [(CH₂)₃-OC(O)O]- or -[(CH₂)₂CH(CH₃)(CH₂)₂-OC(O)O]-. Note that the number average molecular weight is the value of polystyrene obtained by gel permeation chromatography analysis. To homogeneously perform a crosslinking reaction between polycarbonate polyol and the crosslinking compound (that is, to perform control such that the molecular weight does not locally increase), an end hydroxyl group index is preferably 92.5 to 98.5, and more preferably 95.0 to 97.5. If the amount of end hydroxyl group is large, a high-molecular-weight product readily forms in the crosslinking reaction. If the amount of end hydroxyl group is small, the crosslinking reaction does not sufficiently progress, and the molecular weight distribution of the product expands, or the hydrolysis resistance after crosslinking becomes insufficient. Note that the end hydroxyl group index is the peak area ratio (%) of polyol to the total peak area of monoalcohol and polyol, which is analyzed by gas chromatography. Gas chromatography is performed by increasing the temperature from 40°C to 220°C at a rate of 10°C/min, holding the temperature for 15 min, and performing analysis by using a flame ionization detector (FID). Examples of commercially available products are "NIPPOLLAN" series manufactured by NIPPON POLYURETHANE, "PCDL" manufactured by ASAHI KASEI CHEMICALS, and "PLACCEL CD" series manufactured by DAICEL CHEMICAL.

### <Crosslinking Compound>

The crosslinking compound is not particularly limited as long as it is a compound or polymer having, per molecule, two or more functional groups that cause a crosslinking curing reaction with a hydroxyl group of polycaprolactone polyol and/or polycarbonate polyol, and it is possible to appropriately selectively use one type or two or more types of crosslinking compounds. Examples of the crosslinking compound are compounds or polymers having a phenol group, epoxy group, melamine group, isocyanate group, and dialdehyde group. Compounds or polymers having an epoxy group, melamine group, and isocyanate group are favorable in respect of the crosslinking reactivity and pot life, and an isocyanate group and/or epoxy group is particularly favorable in respect of pot life control. Furthermore, an isocyanate compound is desirable as a two-part reactive coating agent in respect of the reactivity of components, the weather resistance resulting from the reactivity, and the hardness and flexibility of the coating layer.

Polyisocyanate can be one of diisocyanate, a dimer (uretdione) of diisocyanate, a trimer (isocyanurate, a triol adduct, or biuret) of diisocyanate, or a mixture of two or more types thereof. Examples of the diisocyanate component are 2,4-trilenediisocyanate, 2,6-trilenediisocyanate, p-phenylenediisocyanate, diphenylmethanediisocyanate, m-phenylenediisocyanate, hexamethylenediisocyanate, tetramethylenediisocyanate, 3,3'-dimethoxy-4,4'-biphenylenediisocyanate, 1,5-naphthalenediisocyanate, 2,6-naphthalenediisocyanate, 4,4'-diisocyanatediphenyl ether, 1,5-xylylenediisocyanate, 1,3-diisocyanatemethylcyclohexane, 1,4-diisocyanatemethylcyclohexane, 4,4'-diisocyanatecyclohexane, 4,4'-diisocyanatecyclohexylmethane, isophoronediisocyanate, dimer acid diisocyanate, and norbornenediisocyanate. Xylylenediisocyanate (XDI), isophoronediisocyanate (IPDI), and hexamethylenediisocyanate (HDI) are favorable in respect of the non-yellowing properties. Also, an isocyanurate form and biuret form of hexamethylenediisocyanate are favorable in respect of the fastness, gas barrier properties, and weather resistance.

The epoxy resin is not particularly limited as long as it is a compound having two or more epoxy groups in one molecule. Examples are sorbitol polyglycidyl ether, sorbitan polyglycidyl ether, polyglycerol polyglycidyl ether, pentaerythritol polyglycidyl ether, triglycidyl, tris(2-hydroxyethyl)isocyanurate, neopentyl glycol diglycidyl ether, 1,6-hexandiol diglycidyl ether, ethyleneglycol diglycidyl ether, and bisphenol type epoxy resins.

The use amount of the above-mentioned crosslinking compound is not particularly limited, and can properly be determined in accordance with, for example, the type of crosslinking compound. However, the reactive group ratio of a hydroxyl group of polycaprolactone polyol and/or polycarbonate polyol to the crosslinking group of the crosslinking compound is desirably hydroxyl group : crosslinking group = 1 : 1 to 1 : 20 in respect of the intra-layer cohesive force and inter-layer adhesion, and more preferably 1 : 1 to 1 : 10. When the crosslinking group ratio falls within this range, the compound is advantageous in adhesion, high-temperature/high-humidity resistance, gas barrier properties, and blocking resistance. To accelerate the crosslinking reaction, it is possible to add, to the above-mentioned crosslinking compound, one type or two or more types of crosslinking catalysts such as salts, inorganic substances, organic substances, acidic substances, and alkaline substances. When using a polyisocyanate compound as the crosslinking compound, for example, one type or two or more types of well-known catalysts such as dibutyl tin laurate and tertiary amine are added. The crosslinking compound can also contain, for example, a silane-based coupling agent, titanium-based coupling agent, light screen, UV absorbent, stabilizer, lubricant, anti-blocking agent, and anti-oxidation agent, or it is possible to use copolymers of these additives and the above-mentioned resins.

### [B-1-3 Weather-Resistant Coating Layer Using Acrylic Copolymer]

In the gas barrier film according to the present invention, an acrylic copolymer can be used as the weather-resistant coating layer. Generally, heat, water, light, or oxygen extracts hydrogen from a polymer chain of the plastic, thereby generating radicals. The generated radicals combine with oxygen to generate highly reactive peroxide radicals, and the peroxide radicals extract hydrogen from another polymer chain, thereby generating radicals again and forming a hydroxy peroxide group at the same time. The hydroxy peroxide group decomposes into hydroxy radicals and oxide radicals, and these radicals extract hydrogen from another polymer chain and generate radicals again. The plastic deteriorates in the process like this. To prevent the deterioration of the plastic, therefore, it is necessary to suppress the generation of radicals caused by heat, water, light, or the like, or suppress the decomposition process. From this viewpoint, it is favorable to use the acrylic copolymer described in this application as the resin forming the weather-resistant coating layer.

In the present invention, the UV-stabilizing group has a function of capturing generated radicals and inactivating them. From the above-mentioned viewpoint, a favorable practical example is a hindered amine group. That is, stable nitroxy radicals generated in the hindered amine group combine with active polymer radicals, return to the stable nitroxy radicals again, and repeat this process. Also, the UV-absorbing group suppresses the generation of radicals by absorbing radiated UV light. From this point of view, favorable practical examples are a benzotriazole group and/or benzophenone group. The cycloalkyl group has a function of imparting a water resistance and water vapor transmission rate to the resin such as the acrylic copolymer forming the weather-resistant coating layer.

Accordingly, the deterioration of the gas barrier properties of the gas barrier film can be prevented by using, in the coating layer, a resin such as an acrylic copolymer having at least one group selected from the group consisting of the UV-stabilizing group, UV-absorbing group, and cycloalkyl group. In the present invention, the combined effect can be obtained for the weather resistance by combining the UV-stabilizing group, UV-absorbing group, and cycloalkyl group. The above-mentioned acrylic copolymer can be obtained by copolymerizing at least one material selected from the group consisting of at least a polymerizable UV-stable monomer, polymerizable UV-absorbing monomer, and cycloalkyl(meth)acrylate.

### <Polymerizable UV-stable Monomer>

The polymerizable UV-stable monomer preferably contains a hindered amine group, and more preferably contains at least one hindered amine group and at least one polymerizable unsaturated group in a molecule. The polymerizable UV-stable monomer is preferably a compound represented by formula (1) or (2) below.

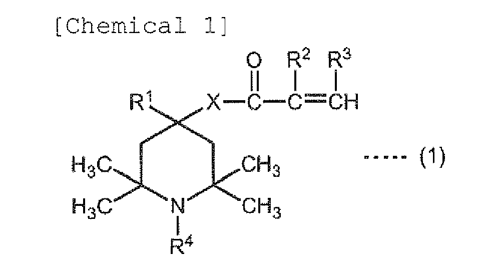

(wherein R¹ represents a hydrogen atom or cyano group, R² and R³ each independently represent a hydrogen atom or a hydrocarbon group having a carbon number of 1 or 2, R⁴ represents a hydrogen atom or a hydrocarbon group having a carbon number of 1 to 18, and X represents an oxygen atom or imino group.)

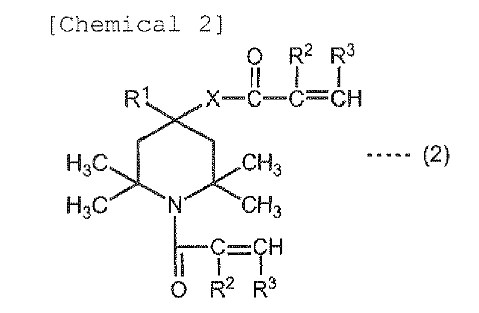

(wherein R¹ represents a hydrogen atom or cyano group, R² and R³ each independently represent a hydrogen atom or a hydrocarbon group having a carbon number of 1 or 2, and X represents an oxygen atom or imino group.)

In the UV-stable monomer represented by formula (1) or (2), practical examples of the 1- to 18-carbon hydrocarbon group indicated by R⁴ are chain hydrocarbon groups such as a methyl group, ethyl group, propyl group, isopropyl group, butyl group, isobutyl group, t-butyl group, pentyl group, hexyl group, heptyl group, octyl group, nonyl group, decyl group, undecyl group, dodecyl group, tridecyl group, tetradecyl group, pentadecyl group, hexadecyl group, heptadecyl group, and octadecyl group; alicyclic hydrocarbon groups such as a cyclopropyl group, cyclopentyl group, cyclohexyl group, cycloheptyl group, and cyclooctyl group; and aromatic hydrocarbon groups such as a phenyl group, tolyl group, xylyl group, benzyl group, and phenethyl group. In the present invention, a hydrogen atom and methyl group are favorable as R⁴ in respect of the light stabilization reactivity. Examples of the 1- or 2-carbon hydrocarbon group represented by each of R² and R³ are a methyl group and ethyl group, and a methyl group is preferable.

Practical examples of the UV-stable monomer represented by formula (1) above are 4-(meth)acryloyloxy-2,2,6,6-tetramethylpiperidine, 4-(meth)acryloylamino-2,2,6,6-tetramethylpiperidine, 4-(meth)acryloyloxy-1,2,2,6,6-pentamethylpiperidine, 4-(meth)acryloylamino-1,2,2,6,6-pentamethylpiperidine, 4-cyano-4-(meth)acryloylamino-2,2,6,6-tetramethylpiperidine, 4-crotonoyloxy-2,2,6,6-tetramethylpiperidine, and 4-crotonoylamino-2,2,6,6-tetrame-thylpiperidine. In the present invention, 4-(meth)acryloyloxy-2,2,6,6-tetramethylpiperidine, 4-(meth)acryloylamino-2,2,6,6-tetramethylpiperidine, 4-(meth)acryloyloxy-1,2,2,6,6-pentamethylpiperidine, and 4-(meth)acryloylamlno-l,2,2,6,6-pentamethylpiperidine are preferable, and 4-methacryloyloxy-2,2,6,6-tetramethylpiperidine and 4-methacryloyloxy-1,2,2,6,6-pentamethylpiperidine are more preferable, in respect of the light stabilization reactivity. It is possible to use one type of these compounds, or properly mix two or more types thereof. The UV-stable monomer represented by formula (1) is, of course, not limited to these compounds.

Practical examples of the UV-stable monomer represented by formula (2) above are 1-(meth)acryloyl-4-(meth)acryloylamino-2,2,6,6-tetramethylpiperidine, 1-(meth)acryloyl-4-cyano-4-(meth)acryloylamino-2,2,6,6-tetramethylpiperidine, and 1-crotonoyl-4-crotoyloxy-2,2,6,6-tetramethylpiperidine. In the present invention, 1-acryloyl-4-acryloylamino-2,2,6,6-tetramethylpiperidine and 1-methacryloyl-4-methacryloylamino-2,2,6,6-tetramethylpiperidine are preferable, and 1-methacryloyl-4-methacryloylamino-2,2,6,6-tetramethylpiperidine is more preferable, in respect of the material versatility. It is possible to use one type of these compounds, or properly mix two or more types thereof. Note that the UV-stable monomer represented by formula (2) is not limited to these compounds.

From the viewpoint of the light stabilization performance, the content of the above-mentioned polymerizable UV-stable monomer is preferably 0.1 to 50 mass%, more preferably 0.2 to 10 mass%, and further preferably 0.5 to 5 mass% in all the polymerizable monomer components for obtaining the acrylic copolymer. A sufficient weather resistance can be achieved when the content falls within the above range.

### <Polymerizable UV-absorbing Monomer>

Preferable examples of the polymerizable UV-absorbing monomer for use in the present invention are polymerizable benzotriazoles and/or polymerizable benzophenones.

### <Polymerizable Benzotriazoles>

In the present invention, a preferable practical example of the polymerizable benzotriazoles is a compound represented by formula (3) below.

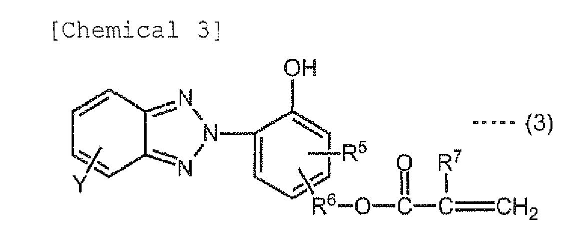

(wherein R⁵ represents a hydrogen atom or a hydrocarbon group having a carbon number of 1 to 8, R⁶ represents a lower alkylene group, R⁷ represents a hydrogen atom or methyl group, Y represents a hydrogen atom, a halogen atom, a hydrocarbon group having a carbon number of 1 to 8, a lower alkoxy group, a cyano group, or a nitro group.)

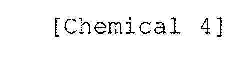

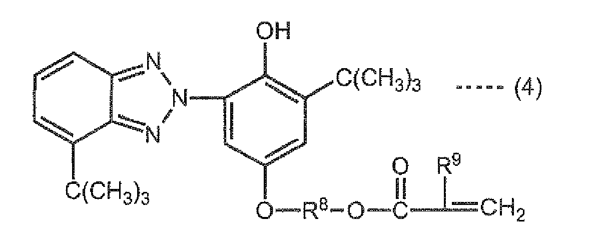

(wherein R⁸ represents an alkylene group having a carbon number of 2 or 3, and R⁹ represents a hydrogen atom or methyl group.)
In the above formulas, practical examples of the 1- to 8-carbon hydrocarbon group represented by R⁵ are chain hydrocarbon groups such as a methyl group, ethyl group, propyl group, isopropyl group, butyl group, isobutyl group, t-butyl group, pentyl group, hexyl group, heptyl group, and octyl group; alicyclic hydrocarbon groups such as a cyclopropyl group, cyclopentyl group, cyclohexyl group, cycloheptyl group, and cyclooctyl group; and aromatic hydrocarbon groups such as a phenyl group, tolyl group, xylyl group, benzyl group, and phenethyl group. R⁵ is preferably a hydrogen atom or methyl group.

The lower alkylene group represented by R⁶ is preferably an alkylene group having a carbon number of 1 to 6. Practical examples are straight-chain alkylene groups such as a methylene group, ethylene group, propylene group, butylene group, pentylene group, and hexylene group, and branched-chain alkylene groups such as an isopropylene group, isobutylene group, s-butylene group, t-butylene group, isopentylene group, and neopentylene group. A methylene group, ethylene group, and propylene group are favorable among other groups. Examples of the substituent represented by Y are hydrogen; halogens such as fluorine, chlorine, bromine, and iodine; the 1- to 8-carbon hydrocarbon group represented by R⁵; 1- to 8-carbon lower alkoxy groups such as a methoxy group, ethoxy group, propoxy group, butoxy group, pentoxy group, and heptoxy group; a cyano group; and a nitro group. A hydrogen atom, chlorine atom, methoxy group, t-butyl group, cyano group, and nitro group are favorable in respect of the reactivity.

Practical examples of the UV-absorbing monomer represented by formula (3) above are 2-[2'-hydroxy-5'-(methacryloyloxymethyl)phenyl]-2H-benzotriazole, 2-[2'-hydroxy-5'-(methacryloyloxyethyl)phenyl]-2H-benzotriazole, 2-[2'-hydroxy-3'-t-butyl-5'-(methacryloyloxyethyl)phenyl]-2H-benzotriazole, 2-[2'-hydroxy-5'-t-butyl-3'-(methacryloyloxyethyl)phenyl]-2H-benzotriazole, 2-[2'-hydroxy-5'-(methacryloyloxyethyl)phenyl]-5-chloro-2H-benzotriazole, 2-[2'-hydroxy-5'-(methacryloyloxyethyl)phenyl]-5-methoxy-2H-benzotriazole, 2-[2'-hydroxy-5'-(methacryloyloxyethyl)phenyl]-5-cyano-2H-benzotriazole, 2-[2'-hydroxy-5'-(methacryloyloxyethyl)phenyl]-t-butyl-2H-benzotriazole, and 2-[2'-hydroxy-5'-(methacryloyloxyethyl)phenyl]-5-nitro-2H-benzotriazole. From the viewpoint of the UV absorbance, favorable examples are 2-[2'-hydroxy-5'-(methacryloyloxymethyl)phenyl]-2H-benzotriazole, 2-[2'-hydroxy-5'-(methacryloyloxyethyl)phenyl]-2H-benzotriazole, 2-[2'-hydroxy-3'-t-butyl-5'-(methacryloyloxyethyl)phenyl]-2H-benzotriazole, and 2-[2'-hydroxy-5'-(methacryloyloxyethyl)phenyl]-t-butyl-2H-benzotriazole, and more favorable examples are 2-[2'-hydroxy-5'-(methacryloyloxymethyl)phenyl]-2H-benzotriazole and 2-[2'-hydroxy-5'-(methacryloyloxyethyl)phenyl]-2H-benzotriazole. It is possible to use only one type of these UV-absorbing monomers represented by formula (3), or properly mix two or more types thereof.

In the UV-absorbing monomer represented by formula (4) above, practical examples of the 2- or 3-carbon alkylene group represented by R⁸ are an ethylene group, trimethylene group, and propylene group. Examples of the UV-absorbing monomer represented by formula (4) above are 2-[2'hydroxy-5'-(β-methacryloyloxyethoxy)-3'-t-butylphenyl]-4-t-butyl-2H-benzotriazole, 2-[2'hydroxy-5'-(β-acryloyloxyethoxy)-3'-t-butylphenyl]-4-t-butyl-2H-benzotriazole, 2-[2'hydroxy-5'-(β-methacryloyloxy n-propoxy)-3'-t-butylphenyl]-4-t-butyl-2H-benzotriazole, and 2-[2'hydroxy-5'-(β-methacryloyloxy i-propoxy)-3'-t-butylphenyl]-4-t-butyl-2H-benzotriazole. From the viewpoint of the UV absorbance, 2-[2'-hydroxy-5'-(β-methacryloyloxyethoxy)-3'-t-butylphenyl]-4-t-butyl-2H-benzotriazole is favorable. It is possible to use only one type of these UV-absorbing monomers represented by formula (4), or properly mix two or more types thereof.

### <Polymerizable Benzophenones>

Polymerizable benzophenones usable as the polymerizable UV-absorbing monomer are, for example, monomers such as 2-hydroxy-4-(3-methacryloyloxy-2-hydroxy-propoxy)benzophenone, 2-hydroxy-4-(3-acryloyloxy-2-hydroxy-propoxy)benzophenone, 2,2'-dihydroxy-4-(3-methacryloyloxy-2-hydroxypropoxy)benzophenone, and 2,2'-dihydroxy-4-(3-acryloyloxy-2-hydroxypropoxy)benzophenone obtained by reacting 2,4-dihydroxybenzophenone or 2,2',4-trihydroxybenzophenone with glycidylacrylate or glycidylmethacrylate. From the viewpoint of the material versatility, 2-hydroxy-4-(3-methacryloyloxy-2-hydroxypropoxy)benzophenone is favorable.

The polymerizable UV-absorbing monomer is used to further increase the weather resistance of the coating layer containing the obtained acrylic copolymer. The content of the polymerizable UV-absorbing monomer in all the polymerizable monomer components is as follows. For polymerizable benzotriazoles, the content is preferably 0.1 to 50 mass%, more preferably 0.5 to 40 mass%, and further preferably 1 to 30 mass%, in order to obtain a sufficient UV absorbance and prevent coloring by UV irradiation. For polymerizable benzophenones, the content is preferably 0.1 to 10 mass%, and more preferably 0.2 to 5.0 mass%, in order to obtain a sufficient UV absorbance and high compatibility.

### <Cycloalkyl(meth)acrylate>

Cyoloalkyl(meth)acrylate for use in the present invention is a component for increasing the hardness, elasticity, solvent resistance, gasoline resistance, and weather resistance of a coating film, when using the obtained acrylic copolymer as a two-part urethane resin paint. Preferable examples of cycloalkyl(meth)acrylate are cyclohexyl(meth)acrylate, methylcyclohexyl(meth)acrylate, t-butylcyclohexyl(meth)acrylate, and cyclododecyl(meth)acrylate. It is possible to use one of these components, or combine two or more types thereof. The content of this cycloalkyl(meth)acrylate in the polymerizable monomer components is preferably 5 to 80 mass%, more preferably 10 to 70 mass%, and further preferably 15 to 50 mass%. When the use amount falls within the above range, the performances such as the hardness and weather resistance of the coating film are sufficiently achieved, and both the drying properties and leveling properties can be obtained.

### <Crosslinking Functional Group>

The acrylic copolymer of the above-mentioned, weather-resistant coating layer preferably has a crosslinking functional group, and the coating layer is preferably formed by crosslinking with a crosslinking compound. Since this gives the aforementioned acrylic copolymer a crosslinking structure, the physical properties and weather resistance of the coating layer improve. As a consequence, a high weather resistance is maintained over a long period of time. Examples of the crosslinking functional group of the above-mentioned acrylic copolymer are a hydroxyl group, an amino group, a carboxyl group or its anhydride, an epoxy group, and an amide group. Either one type or two or more types of these crosslinking function groups can exist in the acrylic copolymer. In the present invention, crosslinking functional groups having active hydrogen such as a hydroxyl group, amino group, and carboxyl group are favorable among other groups in respect of the stability.

Examples of the polymerizable unsaturated monomer having a hydroxyl group are (meth)acryl monomers having a hydroxyl group, such as hydroxyethyl(meth)acrylate, hydroxypropyl(meth)acrylate, caprolactone modified hydroxy(meth)acrylate, and mono(meth)acrylate of polyesterdiol obtained from phthalic acid and propylene glycol. Of these monomers, hydroxypropylacrylate and hydroxyethylmethacrylate are favorable. It is possible to use one of these monomers, or combine two or more types thereof. The polymerizable monomer having the crosslinking function group is a component required to react with crosslinking compounds such as polyisocyanate, when forming a resin composition for a thermosetting paint by mixing these crosslinking compounds in the obtained acrylic copolymer. The content of this polymerizable monomer in all the polymerizable monomer components is 2 to 35 mass%, and preferably 3.5 to 23 mass%. When the use amount falls within this range, the amount of crosslinking functional group in the obtained acrylic copolymer is appropriate. Accordingly, the reactivity between the acrylic copolymer and the crosslinking compounds is maintained, the crosslinking density becomes sufficient, and the target coating film performance is obtained. In addition, the storage stability after the crosslinking compounds are mixed is high.

### <Other Polymerizable Unsaturated Monomers>

In the present invention, other polymerizable unsaturated monomers for forming an acrylic copolymer can be used. Examples of the other polymerizable unsaturated monomers usable in the present invention are (meth)acrylic acid alkyl esters such as methyl(meth)acrylate, ethyl(meth)acrylate, propyl(meth)acrylate, isopropyl(meth)acrylate, butyl(meth)acrylate, isobutyl(meth)acrylate, tertiary butyl(meth)acrylate, 2-ethylhexyl(meth)acrylate, lauryl(meth)acrylate, and stearyl(meth)acrylate; epoxy group-containing unsaturated monomers such as glycidyl(meth)acrylate; nitrogen-containing unsaturated monomers such as (meth)acrylamide, N,N'-dimethylaminoethyl(meth)acrylate, vinylpyridine, and vinylimidazole; halogen-containing unsaturated monomers such as vinyl chloride and vinylidene chloride; aromatic unsaturated monomers such as styrene, α-methylstyrene, and vinyltoluene; vinylesters such as vinyl acetate; vinyl ether; and unsaturated cyan compounds such as (meth)acrylonitrile. It is possible to use one type or two or more types of monomers selected from the group consisting of these monomers.

From the viewpoint of the internal catalyst action during the crosslinking reaction, a polymerizable unsaturated monomer having an acidic functional group can also be used. Examples are carboxyl group-containing unsaturated monomers such as (meth)acrylic acid, crotonic acid, itaconic acid, maleic acid, and anhydrous maleic acid; sulfonic acid group-containing unsaturated monomers such as vinyl sulfonic acid, styrene sulfonic acid, and sulfoethyl(meth)acrylate; and acidic phosphate ester-based unsaturated monomers such as 2-(meth)acryloyloxyethyl acid phosphate, 2-(meth)acryloyloxypropyl acid phosphate, 2-(meth)acryloyloxy-2-chloropropyl acid phosphate, and 2-methacryloyloxyethylphenyl phosphate. It is possible to use one type or two or more types of monomers selected from the group consisting of these monomers.

The above-mentioned other polymerizable monomers can be used as needed within a range in which the function of the acrylic copolymer according to the method of the present invention is not spoiled, and the use amount can be 0 to 92.9 mass% in the polymerizable monomer components. Also, the polymerizable monomer having an acidic functional group among the other polymerizable monomers functions as an internal catalyst when the acrylic copolymer causes a crosslinking reaction with the crosslinking compound, and the content is 0 to 5 mass%, and preferably 0.1 to 3 mass% in the polymerizable monomer components.

### <Method of Polymerizing Acrylic Copolymer>

A method of obtaining the acrylic copolymer by using the aforementioned monomers is not particularly limited, and conventionally known polymerization methods can be used. When using a solution polymerization method, for example, examples of a usable solvent are high-boiling-point aromatic solvents such as toluene and xylene; ester-based solvents such as ethyl acetate, butyl acetate, cellosolve acetate, and propylene glycol monomethyl ether acetate; ketone-based solvents such as methyl ethyl ketone and methyl isobutyl ketone; aliphatic alcohols such as isopropanol, n-butanol, and isobutanol; and alkylene glycol monoalkyl ethers such as propylene glycol monomethyl ether, propylene glycol monoethyl ether, and diethylene glycol monoethyl ether. It is possible to use one type or a mixture of two or more types of these solvents.

Examples of the polymerization initiator are ordinary radical polymerization initiators such as 2,2'-azobis-(2-methylbutylonitrile), t-butylperoxy-2-ethylhexanoate, 2,2'-azobisisobutylonitrile, benzoyl peroxide, and di-t-butyl peroxide. These initiators can be used singly, and can also be used as a combination of two or more types thereof. The use amount is not particularly limited, and can properly be set in accordance with the characteristics of a desired acrylic resin. The reaction conditions such as the reaction temperatures and reaction time are not particularly limited. For example, the reaction temperature is room temperature to 200°C, and preferably 40°C to 140°C. The reaction time can appropriately be set so as to complete the polymerization reaction, in accordance with the composition of monomer components and the type of polymerization initiator.

### <Crosslinking Compound>

The crosslinking compound is not particularly limited as long as it is a compound or polymer having, per molecule, two or more functional groups that cause a crosslinking curing reaction with the above-described crosslinking functional groups, and it is possible to appropriately select one type or two or more types in accordance with the type of functional group of the above-mentioned acrylic copolymer. For example, when the crosslinking group of the acrylic copolymer is a hydroxyl group, examples of the crosslinking compound are compounds or polymers having a phenol group, epoxy group, melamine group, isocyanate group, and dialdehyde group. Compounds or polymers having an epoxy group, melamine group, and isocyanate group are favorable in respect of the crosslinking reactivity and pot life, and an isocyanate group is particularly favorable in respect of pot life control.

When the crosslinking functional group of the acrylic copolymer is a carboxyl group or its anhydride, examples are crosslinking compounds such as a polyisocyanate compound or its modified product, an aminoplast resin, and an epoxy resin. When the crosslinking functional group is an epoxy group, examples are crosslinking compounds containing amine, carboxylic acid, amide, and a compound such as N-methylolalkyl ether. When the crosslinking functional group is a hydroxyl group or amino group, examples are crosslinking compounds such as a polyisocyanate compound or its modified product, an aminoplast resin, and an epoxy resin. Among other compounds, a polyisocyanate compound and/or epoxy resin is favorable to make a combination with a group having active hydrogen. That is, it is preferable to use an isocyanate compound, an epoxy compound, or a combination of an isocyanate compound and epoxy compound, as the crosslinking compound. In the present invention, a combination of a hydroxyl group as the crosslinking functional group and an isocyanate compound as the crosslinking compound is desirable as a two-part reactive coating agent in respect of the reactivity of components, the weather resistance resulting from the reactivity, and the hardness and flexibility of the coating layer.

Polyisocyanate can be one of diisocyanate, a dimer (uretdione) of diisocyanate, a trimer (isocyanurate, a triol adduct, or biuret) of diisocyanate, or a mixture of two or more types thereof. Examples of the diisocyanate component are 2,4-trilenediisocyanate, 2,6-trilenediisocyanate, p-phenylenediisocyanate, diphenylmethanediisocyanate, m-phenylenediisocyanate, hexamethylenediisocyanate, tetramethylenediisocyanate, 3,3'-dimethoxy-4,4'-biphenylenediisocyanate, 1,5-naphthalenediisocyanate, 2,6-naphthalenediisocyanate, 4,4'-diisocyanatediphenyl ether, 1,5-xylylenediisocyanate, 1,3-diisocyanatemethylcyclohexane, 1,4-diisocyanatemethylcyclohexane, 4,4'-diisocyanatecyclohexane, 4,4'-diisocyanatecyclohexylmethane, isophoronediisocyanate, dimer acid diisocyanate, and norbornenediisocyanate. Xylylenediisocyanate (XDI), isophoronediisocyanate (IPDI), and hexamethylenediisocyanate (HDI) are favorable in respect of the non-yellowing properties. Also, an isocyanurate form and biuret form of hexamethylenediisocyanate are favorable in respect of the fastness, gas barrier properties, and weather resistance.

The epoxy resin is not particularly limited as long as it is a compound having two or more epoxy groups in one molecule. Examples are sorbitol polyglycidyl ether, sorbitan polyglycidyl ether, polyglycerol polyglycidyl ether, pentaerythritol polyglycidyl ether, triglycidyl, tris(2-hydroxyethyl)isocyanurate, neopentyl glycol diglycidyl ether, 1,6-hexandiol diglycidyl ether, ethylene glycol diglycidyl ether, and a bisphenol type epoxy resin.

The use amount of the above-mentioned crosslinking compound is not particularly limited, and can properly be determined in accordance with the type of crosslinking compound or the like. However, the reactive group ratio of the crosslinking group (for example, a hydroxyl group) of the acrylic copolymer to the crosslinking group of the crosslinking compound is desirably hydroxyl group : crosslinking group = 1 : 1 to 1 : 20 in respect of the intra-layer cohesive force and inter-layer adhesion, and more preferably 1 : 1 to 1 : 10. When the crosslinking group ratio falls within this range, the compound is advantageous in adhesion, high-temperature/high-humidity resistance, gas barrier properties, and blocking resistance. To accelerate the crosslinking reaction, it is possible to add, to the above-mentioned crosslinking compound, one type or two or more types of crosslinking catalysts such as salts, inorganic substances, organic substances, acidic substances, and alkaline substances. When using a polyisocyanate compound as the crosslinking compound, for example, one type or two or more types of well-known catalysts such as dibutyl tin laurate and tertiary amine can be added. The crosslinking compound can also contain, for example, a silane-based coupling agent, titanium-based coupling agent, light screen, UV absorbent, stabilizer, lubricant, anti-blocking agent, and anti-oxidation agent, or it is possible to use copolymers of these additives and the above-mentioned resins.

### [B-1-4 Method of Forming Weather-Resistant Coating Layer]

Each of the weather-resistant coating layer using the modified polyvinyl alcohol, the weather-resistant coating layer using at least one of polycaprolactone polyol and polycarbonate polyol, and the weather-resistant coating layer using the acrylic copolymer explained above can be formed by properly selecting a well-known coating method. For example, it is possible to use any coating method using a reverse roll coater, gravure coater, rod coater, air doctor coater, spray, or brush. It is also possible to dip a deposition film in a resin solution. After coating, the solvent can be evaporated by using a well-known drying method, for example, heat drying such as hot-air drying at a temperature of about 80°C to 200°C or heated-roll drying, or infrared drying. Also, a crosslinking process can be performed by electron beam irradiation in order to increase the water resistant and durability.

The thickness of the weather-resistant coating layer is preferably about 0.005 to 5 µm, and more preferably 0.01 to 1 µm. When the thickness is 5 µm or less, the slip characteristics improve, and there is almost no peeling from the substrate film by the internal stress of the anchor coating layer itself. When the thickness is 0.005 µm or more, a uniform thickness can be held. Also, since the weather-resistant coating layer planarizes the substrate film surface, particles forming a thin inorganic film densely deposit to form a uniform film, so high gas barrier properties can be obtained.

### [B-2 Other Layers of Gas Barrier Film]

The gas barrier film of the present invention can include a substrate film layer, inorganic thin film layer, protective layer, and filler, in addition to the weather-resistant coating layer. In particular, in the gas barrier film according to the present invention, at least the substrate film layer, weather-resistant coating layer, and inorganic thin film layer are preferably laminated in this order. That is, a gas barrier film including a substrate film, a weather-resistant coating layer formed on at least one surface of the substrate film, and an inorganic thin film layer formed on the surface of the weather-resistant coating layer is favorable. The layers other than the weather-resistant coating layer will be explained in detail below.

### [B-2-1 Substrate film]

A thermoplastic polymer film is preferable as the substrate film of the gas barrier film of the present invention, and a resin usable as an ordinary packaging material can be used as the material without any limitations. Practical examples are polyolefin such as homopolymers or copolymers, for example, ethylene, propylene, and butene, amorphous polyolefin such as cyclic polyolefin, polyester such as polyethyleneterephthalate and polyethylene-2,6-naphthalate, polyamide such as nylon 6, nylon 66, nylon 12, and copolymerized nylon, an ethylene-vinyl acetate copolymer partial hydrolysate (EVOH), polyimide, polyetherimide, polysulfone, polyethersulfone, polyetheretherketone, polycarbonate, polyvinylbutyral, polyarylate, a fluorine resin, an acrylate resin, and a biodegradable resin. Among other resins, polyester, polyamide, and polyolefin are favorable in respect of the physical properties and cost. Polyethyleneterephthalate and polyethylenenaphthalate are particularly favorable in respect of the film physical properties. The above-mentioned substrate film can also contain well-known additives, for example, an antistatic agent, light screen, UV absorbent, plasticizer, lubricant, filler, colorant, stabilizer, lubricating agent, crosslinking agent, anti-blocking agent, and anti-oxidation agent.

The thermoplastic polymer film as the above-mentioned substrate film is obtained by molding the above-mentioned materials, and can be either unstretched or stretched when used as a base. The thermoplastic polymer film can also be laminated on another plastic base. A substrate film like this can be manufactured by conventional well-known methods.
For example, an unstretched film that is practically amorphous and unaligned can be manufactured by melting a material resin by an extruder, extruding the molten resin by an annular die or T-die, and rapidly cooling the extruded resin. It is also possible, by using a multilayered die, to manufacture a single-layered film made of one type of a resin, a multilayered film made of one type of a resin, and a multilayered film made of various types of resins. A film stretched in at least a uniaxial direction can be manufactured by stretching the unstretched film in a machine (longitudinal) direction, or in the machine direction and a (transverse) direction perpendicular to the machine direction, by using a well-known method such as uniaxial stretching, tenter-type sequential biaxial stretching, tenter-type simultaneous biaxial stretching, or tubular-type simultaneous biaxial stretching. Although the stretching magnification is freely settable, the heat shrinkage ratio at 150°C is preferably 0.01 to 5%, and more preferably 0.01 to 2%. From the viewpoint of the film physical properties, a biaxially stretched polyethylenenaphthalate film or a coextruded biaxially stretched film made of polyethyleneterephthalate and/or polyethylenenaphthalate and another plastic is particularly favorable.

The thickness of the substrate film is normally 5 to 500 µm, and preferably 10 to 200 µm in accordance with the application of the substrate film, from the viewpoints of the mechanical strength, plasticity, transparency, and the like of the gas barrier laminated film of the present invention as a base, and the substrate film includes a sheet having a large thickness. Also, the width and length of the film are not particularly limited, and can be selected in accordance with the application. Furthermore, to improve the coating properties and adhesion of the anchor coating agent to the substrate film, an ordinary surface treatment such as a chemical treatment or discharge treatment can be performed on the film before it is coated with the anchor coating agent.

### [B-2-2 Inorganic Thin Film]

Although any method such as deposition or coating can be used as a method of forming the thin inorganic film, deposition is preferable because a uniform thin film having high gas barrier properties is obtained. This deposition includes physical vapor deposition (PVD), chemical vapor deposition (CVD), and the like. Examples of the physical vapor deposition are vacuum deposition, ion plating, and sputtering, and examples of the chemical vapor deposition are plasma CVD using plasma, and catalyst chemical vapor deposition (Cat-CVD) that causes catalyst pyrolysis of a source gas by using a heated catalyst. In addition, it is favorable to give the thin inorganic film a multilayered structure because high gas barrier properties can stably be maintained for a long time period. For that purpose, various deposition methods can be combined. For example, a multilayered inorganic thin film structure such as a vacuum deposition film/vacuum deposition film, a vacuum deposition film/plasma CVD film, a vacuum deposition film/plasma processing/vacuum deposition film, a vacuum deposition film/plasma CVD film/vacuum deposition film, a vacuum deposition film/Cat-CVD film/vacuum deposition film, a vacuum deposition film/weather-resistant coat/vacuum deposition film, a plasma CVD film/vacuum deposition film, or a plasma CVD film/vacuum deposition film/plasma CVD film can be formed on the weather-resistant coating layer. The multilayered structure of a vacuum deposition film/plasma CVD film is particularly favorable in respect of the gas barrier properties, adhesion, and productivity.

Examples of the inorganic substance forming the thin inorganic film are silicon, aluminum, magnesium, zinc, tin, nickel, titanium, and hydrogenated carbon; oxides, carbides, and nitrides of these elements; and mixtures of these compounds. Preferable examples are silicon oxide, aluminum oxide, and diamond-like carbon mainly containing hydrogenated carbon. In particular, silicon oxide, silicon nitride, silicon oxynitride, and aluminum oxide are favorable because high gas barrier properties can stably be maintained. Furthermore, silicon oxide, silicon nitride, and silicon oxynitride are suitable for a solar cell module because the gas barrier property maintaining performance at a high temperature and high humidity is high.

The source gas usable in chemical vapor deposition preferably contains at least one type of a gas. In the formation of a thin silicon compound film, for example, it is favorable to use ammonia, nitrogen, oxygen, hydrogen, or a rare gas such as argon as a second source gas with respect to a first source gas containing silicon. As the first source gas containing silicon, it is possible to use one or a combination of two types of monosilane, tetramethoxysilane, methyltrimethoxysilane, dimethyldimethoxysilane, phenyltrimethoxysilane, diphenyldimethoxysilane, tetraethoxysilane, methyltriethoxysilane, dimethyldiethoxysilane, phenyltriethoxysilane, diphenyldiethoxysilane, hexyltrimethoxysilane, hexyltriethoxysilane, decyltrimethoxysilane, decyltrimethoxysilane, trifluoropropyltrimethoxysilane, hexamethyldisiloxane, and hexamethyldisilazane. Also, the source gas can be either a liquid or gas at room temperature, and a liquid material can be supplied into an apparatus after being vaporized by a material vaporizer. In the catalyst chemical vapor growth method, monosilane gas is preferable in respect of deterioration of the heated catalyst, the reactivity, and the reaction speed.

The thickness of each thin organic film is normally about 0.1 to 500 nm, preferably 0.5 to 100 nm, and more preferably 1 to 50 nm. When the thickness falls within this range, sufficient gas barrier properties are obtained, and the productivity is high because the thin inorganic film neither cracks nor peels.

### [B-2-3 Protective Layer]

The gas barrier film of the present invention can include a protective layer in order to protect the uppermost layer of the thin inorganic film. As a resin for forming this protective layer, any solvent-soluble resin or aqueous resin can be used. More specifically, it is possible to use one or a combination of two or more types of, for example, a polyester-based resin, urethane-based resin, acrylic resin, polyvinyl alcohol-based resin, ethylene vinyl alcohol-based resin, vinyl modified resin, nitrocellulose-based resin, silicon-based resin, isocyanate-based resin, epoxy-based resin, oxazoline group-containing resin, modified styrene-based resin, modified silicon-based resin, and alkyl titanate. As the protective layer, it is also possible to use a layer obtained by mixing one or more types of inorganic particles selected from silica sol, alumina sol, particulate inorganic filler, and layered inorganic filler, in the above-mentioned one or more types of resins, or a layer made of an inorganic particle-containing resin formed by polymerizing the material of the above-mentioned resin in the presence of the inorganic particles.

As the resin for forming the protective layer, the aforementioned aqueous resin is favorable in order for improving the gas barrier properties of the thin inorganic film. In addition, a vinyl alcohol resin or ethylene vinyl alcohol resin is favorable as the aqueous resin. As the protective layer, it is also possible to use a resin layer obtained by forming a coating film of an aqueous solution containing polyvinyl alcohol and an ethylene-unsaturated carboxylic acid copolymer.

The thickness of the protective layer is preferably 0.05 to 10 µm, and more preferably 0.1 to 3 µm in respect of the printability and processability. A well-known coating method is properly selected as a method of forming the protective layer. For example, it is possible to use any coating method using a reverse roll coater, gravure coater, rod coater, air doctor coater, spray, or brush. It is also possible to dip a deposition film in a resin solution for the protective layer. After coating, the water component can be evaporated by using a well-known drying method, for example, heat drying such as hot-air drying at a temperature of about 80°C to 200°C or heated-roll drying, or infrared drying. Also, a crosslinking process can be performed by electron bream irradiation in order to increase the water resistance and durability.

The water vapor transmission rate (WvTR) of the gas barrier film of the present invention is 0 < WvTR ≤ 0.1 (g/m²/day) at 40°C and a relative humidity of 90%. When the water vapor transmission rate falls within this range, the decrease in energy conversion efficiency of the solar cell module, particularly, the decrease in energy conversion efficiency after exposure to a high temperature and high humidity is small. The water vapor transmission rate WvTR is more preferably 0.0001 ≤ WvTR ≤ 0.05 (gfm²/day), and further preferably 0.0003 ≤ WvTR ≤ 0.005 (g/m²/day). Note that when the water vapor transmission rate WvTR is 0.01 g/m²/day or more, the water vapor transmission rate WvTR is measured using gravimetry in order to increase the measurement accuracy. Note also that when the water vapor transmission rate WvTR is less than 0.01 g/m²/day, the water vapor transmission rate WvTR is measured using a differential pressure method. Detailed measurement methods using gravimetry or the differential pressure method will be explained later in the section of examples.

The solar cell module according to the present invention need only include at least solar cell element (A) and gas barrier film (B) described above, but preferably further includes substrate (C) and layer (D) containing a scavenger for absorbing water and/or oxygen. It is more favorable to further include one or a plurality of corrosion-resistant layers (E) between the electrode opposite to the substrate and layer (C) containing a scavenger for absorbing water and/or oxygen. These components will be explained in detail below. In the present invention, all of a sheet, film, and layer mean sheet-like and film-like members, and they will not be distinguished from each other as long as the functions of the present invention are not spoiled.

### [C Substrate]

Substrate (C) is a support member for supporting solar cell element (A). Examples of a material forming substrate (C) are inorganic materials such as glass, sapphire, and titania; organic materials such as polyethyleneterephthalate, polyethylenenaphthalate, polyethersulfone, polyimide, nylon, polystyrene, polyvinyl alcohol, an ethylene-vinyl alcohol copolymer, a fluorine resin film, vinyl chloride, polyethylene, polypropylene, cyclic polyolefin, cellulose, acetylcellulose, polyvinylidene chloride, aramid, polyphenylene sulfide, polyurethane, polycarbonate, a poly(meth)acrylic resin, a phenol resin, an epoxy resin, polyarylate, and polynorbornene; and metal materials such as stainless steel, titanium, nickel, silver, gold, copper, and aluminum.

Among other materials, glass, polyethyleneterephthalate, polyethylenenaphthalate, polyimide, a poly(meth)acrylic resin film, stainless steel, and aluminum are favorable in respect of the easiness of formation of solar cell element (A). Note that it is possible to use one type of these substrate materials, or to use an arbitrary combination of two or more types thereof at an arbitrary ratio. It is also possible to increase the mechanical strength by mixing reinforcing fibers such as carbon fibers or glass fibers in these organic materials. Furthermore, composite materials obtained by coating or laminating the surfaces of these metal materials to give them insulating properties can also be used.

### [D Layer Containing Scavenger for Absorbing Water and/or Oxygen]

Layer (D) containing a scavenger for absorbing water and/or oxygen is a film that absorbs water and/or oxygen. As described earlier, the components of the organic thin-film solar cell element include those which deteriorate due to water and those which deteriorate due to oxygen. This makes it difficult to prolong the life while maintaining the power generation efficiency without maximally eliminating these factors.

Accordingly, layer (D) containing a scavenger for absorbing water and/or oxygen covers the solar cell element, thereby protecting the solar cell element and the like against water and/or oxygen, and maintaining a high power generation capability. Unlike gas barrier film (B) as described above, layer (D) containing a scavenger for absorbing water and/or oxygen does not prevent the transmission of water and/or oxygen, but absorbs water and/or oxygen. By using the film that absorbs water and/or oxygen, layer (D) containing a scavenger for absorbing water and/or oxygen scavenges water and/or oxygen slightly entering a space formed by gas barrier film (B) and a sealing member when covering the solar cell element with gas barrier film (B) and the like, thereby eliminating the influence of water on the solar cell element.

Also, since layer (D) containing a scavenger for absorbing water and/or oxygen absorbs oxygen, layer (D) containing a scavenger for absorbing water and/or oxygen scavenges oxygen slightly entering the space formed by gas barrier film (B) and the sealing member when covering the solar cell element with gas barrier film (B) and the like, thereby eliminating the influence of oxygen on the solar cell element.

Materials forming layer (D) containing a scavenger for absorbing water and/or oxygen are arbitrary materials as long as they can absorb water and/or oxygen. Examples of a substance (water absorbent or desiccant) that absorbs water are an alkali metal, an alkali earth metal, an oxide of an alkali earth metal, a hydroxide of an alkali metal or alkali earth metal, silica gel, a zeolite-based compound, sulfates such as magnesium sulfate, sodium sulfate, and nickel sulfate, an aluminum metal complex, and an organic metal compound such as aluminum oxide octylate. Practical examples of the alkali earth metal are Ca, Sr, and Ba. Practical examples of the oxide of the alkali earth metal are CaO, SrO, and BaO. Other examples are Zr-Al-BaO and an aluminum metal complex. Among other materials, Ca and Sr as alkali earth metals, CaO and SrO as oxides thereof, and an aluminum metal complex are favorable. CaO, SrO, and BaO are more favorable because the water scavenging ability is high, and an aluminum metal complex is more favorable because the scavenger can be made transparent.

As a practical product of the preferable examples, it is favorable to use OleDry (manufactured by Futaba) as the scavenger for absorbing water. Examples of a substance (oxygen scavenger) for absorbing oxygen are inorganic substances such as Fe, Mn, Zn, and inorganic salts, for example, sulfates, chloride salts, and nitrates of these metals; and organic substances such as ascorbic acid, a hydrazine-based compound, MXD6 nylon, ethylenic unsaturated hydrocarbon, and a polymer having a cyclohexene group.

Note that layer (D) containing a scavenger for absorbing water and/or oxygen can be formed by one type of a material or two or more types of materials.

As combinations of water-absorbing scavengers forming layer (D) containing a scavenger for absorbing water and/or oxygen, a combination of Ca or Sr as an alkali earth metal and CaO or SrO as an oxide of the alkali earth metal; and a combination of CaO or SrO as an oxide of an alkali earth metal and an aluminum metal complex are favorable in respect of the water scavenging performance. As combinations of water-absorbing scavengers and oxygen-absorbing scavengers, a combination of CaO or SrO as an oxide of an alkali earth metal and Fe; a combination of CaO or SrO as an oxide of an alkali earth metal and ascorbic acid; a combination of CaO or SrO as an oxide of an alkali earth metal and a hydrazine compound; a combination of an aluminum metal complex and ascorbic acid; and a combination of an aluminum metal complex and hydrazine compound are favorable in order to absorb both water and oxygen. A combination of CaO or SrO as an oxide of an alkali earth metal and ascorbic acid; and a combination of CaO or SrO as an oxide of an alkali earth metal and a hydrazine compound are more favorable because the absorbing performance further improves.

Layer (D) containing a scavenger for absorbing water and/or oxygen can be formed by a single-layered film, and can also be a laminated film including two or more films. Although the thickness of layer (D) containing a scavenger for absorbing water and/or oxygen is not particularly defined, the thickness is normally 5 µm or more, preferably 10 µm or more, and more preferably 15 µm or more, and is normally 500 µm or less, preferably 400 µm or less, and more preferably 300 µm or less. The mechanical strength increases when the thickness is increased, and the flexibility increases and the device can be made thin when the thickness is decreased.

In one embodiment, layer (D) containing a scavenger for absorbing water and/or oxygen is formed on the light receiving surface side of solar cell element (A). In another embodiment, layer (D) containing a scavenger for absorbing water and/or oxygen is formed on the reverse surface side of solar cell element (A) as needed. In still another embodiment, layer (D) containing a scavenger for absorbing water and/or oxygen is formed on each of the light receiving surface side and reverse surface side. In this case, on both the light receiving surface and reverse surface, layer (D) containing a scavenger for absorbing water and/or oxygen is preferably positioned between solar cell element (A) and gas barrier film (B).

The formation position of layer (D) containing a scavenger for absorbing water and/or oxygen is not limited, provided that the layer is formed in a space formed by gas barrier film (B) and a sealing member, in addition to the above-mentioned position. For example, layer (D) containing a scavenger for absorbing water and/or oxygen can be formed on substrate (C) where no solar cell element (A) exists, on gas barrier film (B) except for the light receiving surface and/or the rear projection surface of solar cell element (A), or in a device peripheral portion, particularly, inside the sealing member.

Layer (D) containing a scavenger for absorbing water and/or oxygen can be formed by an arbitrary method in accordance with the type of scavenger. For example, it is possible to use a method of adhering a film in which the scavenger is dispersed by using an adhesive, or a method of forming a coat of a scavenger solution by, for example, roll coating, gravure coating, knife coating, dip coating, curtain flow coating, spray coating, bar coating, die coating, spin coating, ink jet, or a dispenser. It is also possible to use a deposition method such as plasma CVD, vacuum deposition, ion plating, or sputtering.

As a film for the scavenger, it is possible to use, for example, a polyethylene-based resin, polypropyrene-based resin, cyclic polyolefin-based resin, polystyrene-based resin, acrylonitrile-styrene copolymer (AS resin), acrylonitrile-butadiene-styrene copolymer (ABS resin), polyvinyl chloride-based resin, fluorine-based resin, poly(meth)acrylic resin, or polycarbonate-based resin. Among other resins, films made of a polyethylene-based resin, fluorine-based resin, cyclic polyolefin-based resin, and polycarbonate-based resin are favorable. Note that it is possible to use one type of these resins, or to use an arbitrary combination of two or more types thereof at an arbitrary ratio.

Since constituent members at the back of the solar cell element need not always transmit visible light, layer (D) containing a scavenger for absorbing water and/or oxygen formed on the reverse surface of the solar cell element, which is opposite to the light receiving surface, can be made of a material that does not transmit visible light. It is also possible to use a film containing a water or oxygen absorbent to be used more than that of layer (D) containing a scavenger for absorbing water and/or oxygen. Examples of the water absorbent are CaO, BaO, and Zr-Al-BaO. Examples of the oxygen absorbent are activated carbon and a molecular sieve.

### [E Corrosion-Resistant Layer]

A material forming corrosion-resistant layer (E) according to the present invention is an arbitrary material. It is noted that corrosion-resistant layer (E) of the present invention is different from a filler. Practical examples of the material of the corrosion-resistant layer are a polyethylene-based resin, polypropylene-based resin, cyclic polyolefin-based resin, α-olefin maleic anhydride copolymer, polystyrene-based resin, acrylonitrile-styrene copolymer (AS resin), styrene-butadiene copolymer (SB resin), acrylonitrile-butadiene-styrene copolymer (ABS resin), polyvinyl chloride-based resin, polyvinylidene chloride-based resin, polyvinyl acetate-based resin, ethylene-vinyl acetate copolymer, polyvinyl alcohol-based resin, ethylene-vinyl alcohol copolymer, polyvinyl butyral-based resin, polyvinyl pyrrolidone-based resin, fluorine-based resin, poly(meth)acrylic resin, polycarbonate-based resin, polyester-based resin such as polyethyleneterephthalate or polyethylenenaphthalate, polyimide-based resin, polyamidoimide-based resin, polyacrylphthalate-based resin, polyamide-based resin, silicone-based resin, polysulfone-based resin, polyethersulfone-based resin, polyphenylene sulfide-based resin, polyurethane-based resin, polybenzoimidazole-based resin, phenolic resin, melamine-based resin, urea resin, resorcinol-based resin, xylene-based resin, epoxy-based resin, acetal-based resin, and cellulose-based resin. Preferable examples are resin materials such as a polyethylene-based resin, cyclic polyolefin-based resin, ethylene-vinyl acetate copolymer, fluorine-based resin, poly(meth)acrylic resin, polycarbonate-based resin, polyester-based resin, polyimide-based resin, and epoxy-based resin, and more preferable examples are a polyethylene-based resin, fluorine-based resin, poly(meth)acrylic resin, polyester-based resin, polyimide-based resin, and epoxy-based resin. Among other materials, a poly(meth)acrylic resin and epoxy-based resin are particularly favorable because an adhesive function can be obtained.

Corrosion-resistant layer (E) includes one or more layers, and may also include a plurality of layers. When using a plurality of layers, a combination of a polyester-based resin and poly(meth)acrylic resin or a combination of a polyester-based resin and epoxy-based resin is favorable because each combination has both transparency and a heat resistance and can achieve an adhesive function.

The thickness of each layer of corrosion-resistant layer (E) is normally 5 to 500 µm, preferably 10 to 200 µm, and more preferably 20 to 100 µm. If the thickness exceeds the upper limit, the thickness of a flexible solar cell module increases, and this makes the module difficult to bend. Also, since the distance to the metal electrode of an element increases, the scavenger may become unable to efficiently absorb water and oxygen having reached the periphery of the metal electrode. On the other hand, if the thickness becomes smaller than the lower limit, the suppression of alkali diffusion becomes insufficient, and this may make it impossible to prevent deterioration of the electrode.

Instead of the above-described formation position, corrosion-resistant layer (E) may also be laminated on a portion of substrate (C) where no solar cell element (A) exists, or on gas barrier film (B). Corrosion-resistant layer (E) can be formed by an arbitrary method in accordance with the type of compound to be used. For example, it is possible to use a method of forming a film or sheet, such as a melt extrusion molding method, solvent casting method, or calendar method, or a wet film formation method of forming a coating film of a solution forming corrosion-resistant layer (E) by, for example, roll coating, gravure coating, knife coating, dip coating, curtain flow coating, spray coating, bar coating, die coating, spin coating, ink jet, or a dispenser.

It is also possible to use a dry deposition method such as plasma CVD, vacuum deposition, ion plating, or sputtering. Furthermore, after a film or sheet is formed or deposited, polymerization, crosslinking, and curing can be performed by heating using a heater, infrared radiation, or microwaves, or by UV and/or visible light irradiation.

### [F Other Elements]

The solar cell module according to the present invention need only include at least solar cell element (A) and gas barrier film (B) as described previously, but can also include at least one of elements to be presented below, that is, a sealing member, encapsulating member, weather-resistant protection sheet, and reverse surface protection sheet.

### [F-1 Sealing Member]

The sealing member is a member for sealing the edges of a laminate formed by at least the solar cell element and gas barrier film, thereby preventing water and oxygen from entering a space covered with these films.

Examples of a material forming the sealing member are polymers such as a fluorine-based resin, silicone-based resin, acrylic resin, α-olefin maleic anhydride copolymer, urethane-based resin, cellulose-based resin, vinyl acetate-based resin, ethylene-vinyl acetate copolymer, epoxy-based resin, vinyl chloride-based resin, phenolic resin, melamine-based resin, urea-based resin, resorcinol-based resin, polyamide-based resin, polyimide-based resin, polystyrene-based resin, polyvinyl butyral-based resin, polybenzoimidazole-based resin, polychloroprene, nitrile rubber, and styrene-butadiene copolymer.

Note that the sealing member can be formed by one type of a material or two or more types of materials. The sealing member is formed in a position where the member can seal at least the edges of gas barrier film (B). This makes it possible to close at least a space surrounded by gas barrier film (B) and the sealing member, and prevent water and oxygen from entering this space.

The sealing member is formed on the edges of substrate (C) to have a thickness of normally 0.5 to 100 mm, preferably 1 to 80 mm, and more preferably 2 to 50 mm, so that solar cell element (A) is positioned inside a square shape.

An adhesion form of the sealing member is not particularly limited as long as substrate (C) and gas barrier film (B) can be adhered without any gap. Examples of the adhesion form are adhesion by curing a sealing agent, fixing by vaporization of a solvent or dispersing medium, hot melt, and adhesion (sticking) by simple lamination. From the viewpoint of the easiness of manufacture, sticking by simple lamination is favorable. Also, since a network obtained by curing improves the gas barrier properties, adhesion by curing is favorable when the sealing member is required to have barrier properties.

Examples of the curing method are curing by a chemical reaction at room temperature, heat curing, photo-curing by visible light or UV radiation, electron beam curing, and anaerobic curing. From the viewpoint of precise curing control, heat curing and UV curing are favorable. The form of the sealing member is properly selected from, for example, a liquid form, gel form, and sheet form, in accordance with the adhesion method. A sheet form is favorable because no liquid leakage occurs during the sealing process.

### [F-2 Encapsulating Member]

In the present invention, the encapsulating member can be used to, for example, reinforce the solar cell module. The encapsulating member preferably has high strength in order to hold the strength of the solar cell module. A practical strength is difficult to unconditionally define because it is related with the strength of the weather-resistant protection sheet or reverse surface protection sheet other than the encapsulating member. However, the encapsulating member preferably has strength with which the whole solar cell module has high bending processability and no peeling occurs in a bent portion.

As a material forming the encapsulating member, a film (EVA film) of an ethylene-vinyl acetate copolymer (EVA) resin composition can be used. However, the crosslinking process of the EVA resin requires a relatively long time, and this sometimes decreases the production speed and production efficiency of an organic semiconductor device. Also, when the solar cell module is used for long time periods, a decomposition gas (acetic acid gas) of the EVA resin composition or a vinyl acetate group of the EVA resin itself sometimes exerts an adverse effect on the solar cell element and decreases the power generation efficiency. Accordingly, a copolymer film made of a propylene-ethylene-α-olefin copolymer can be used as the encapsulating member, instead of the EVA film.

Note that the encapsulating member can be formed by one type of a material or two or more types of materials. Note also that the encapsulating member can be formed by a single-layered film, and can also be a laminated film including two or more films. Although the formation position of the encapsulating member is not limited, the encapsulating member is normally formed to sandwich the solar cell element in order to reliably protect it.

Furthermore, the encapsulating member can be given functions such as UV blocking, heat radiation blocking, conductivity, anti-reflection properties, anti-glare properties, light diffusion, light scattering, wavelength conversion, and gas barrier properties. The encapsulating member preferably has the UV blocking function because a solar cell is exposed to intense UV radiation from the sunlight. As a method of imparting this function, a layer having the function can be laminated on an encapsulating member by coating or the like, or a material that achieves the function can be added to the encapsulating member by dissolution or dispersion.

### [F-3 Weather-Resistant Protection Sheet]

The weather-resistant protection sheet is a sheet or film for protecting the solar cell module from the device installation environments such as a temperature change, a humidity change, light, wind, and rain. When the device surface is covered with the weather-resistant protection sheet, the solar cell module constituent materials, particularly, solar cell element (A) is protected and achieves high power generation performance without any deterioration.

Since the weather-resistant protection sheet is positioned in the uppermost layer of solar cell element (A), the weather-resistant protection sheet preferably has performance suitable as a surface covering member of solar cell element (A), for example, a weather resistance, heat resistance, transparency, water repellency, stain resistance, and mechanical strength, and has properties of maintaining the performance for long time periods outside in an exposed state. A material forming the weather-resistant protection sheet is an arbitrary material as long as it protects the solar cell module. For example, gas barrier film (B) already explained above can also be used as the weather-resistant protection sheet.

Examples of other materials forming the weather-resistant protection sheet are a polyethylene resin, polypropyrene resin, cyclic polyolefin resin, AS (acrylonitrile-styrene) resin, ABS (acrylonitrile-butadiene-styrene) resin, polyvinyl chloride resin, fluorine-based resin, polyester resin such as polyethyleneterephthalate or polyethylenenaphthalate, phenolic resin, polyacrylic resin, polyamide resin such as various types of nylons, polyimide resin, polyamideimide resin, polyurethane resin, cellulose-based resin, silicone-based resin, and polycarbonate resin.

A fluorine-based resin is particularly favorable among other resins. Practical examples are polytetrafluoroethylene (PTFE), a 4-ethylene fluoride-perchloroalkoxy copolymer (PFA), a 4-ethylene fluoride-6-propylene fluoride copolymer (FEP), a 2-ethylene-4-ethylene fluoride copolymer (ETFE), polychlorotrifluoroethylene (PCTFE), polyvinylidene fluoride (PVDF), and polyvinyl fluoride (PVF).

Note that the weather-resistant protection sheet can be formed by one type of a material or two or more types of materials. Note also that the weather-resistant protection sheet can be formed by a single-layered film, and can also be a laminated film including two or more films. Although the thickness of the weather-resistant protection sheet is not particularly defined, the thickness is normally 10 µm or more, preferably 15 µm or more, and more preferably 20 µm or more, and is normally 200 µm or less, preferably 180 µm or less, and more preferably 150 µm or less. The mechanical strength increases when the thickness is increased, and the flexibility increases when the thickness is decreased.

To improve adhesion to other films, a surface treatment such as a corona treatment or plasma treatment can be performed on the weather-resistant protection sheet. The weather-resistant protection sheet is preferably formed on the outermost side of the solar cell module, in order to protect device constituent members as many as possible. It is also possible to give the weather-resistant protection sheet functions such as UV blocking, heat radiation blocking, stain resistance, hydrophilic nature, hydrophobic nature, defogging properties, abrasion resistance, conductivity, anti-reflection properties, anti-glare properties, light diffusion, light scattering, wavelength conversion, and gas barrier properties. The weather-resistant protection sheet preferably has the UV blocking function because a solar cell is exposed to intense UV radiation from the sunlight.

As a method of imparting this function, a layer having the function can be laminated on the weather-resistant protection sheet by coating or the like, or a material that achieves the function can be added to the weather-resistant protection sheet by dissolution or dispersion.

### [F-4 Reverse Surface Protection Sheet]

The reverse surface protection sheet is a sheet or film similar to the above-described weather-resistant protection sheet, so a member similar to the weather-resistant protection sheet can similarly be used except for the formation position. That is, gas barrier film (B) already explained above can also be used as the reverse surface protection sheet. It is also possible to cause this reverse surface protection sheet to function as a gas barrier layer, provided that the reverse surface protection sheet hardly transmits water and oxygen.

Since constituent members at the back of the solar cell element need not always transmit visible light, a material that does not transmit visible light can be used. Accordingly, examples of the reverse surface protection sheet are as follows.

As the reverse surface protection sheet, it is possible to use films and sheets of various types of resins having high strength and superior in weather resistance, heat resistance, water resistance, and light resistance. For example, it is possible to use sheets of various types of resins such as a polyethylene-based resin, polypropylene-based resin, cyclic polyolefin-based resin, polystyrene-based resin, acrylonitrile-styrene copolymer (AS resin), acrylonitrile-butadiene-styrene copolymer (ABS resin), polyvinyl chloride-based resin, fluorine-based resin, poly(meth)acrylic resin, polycarbonate-based resin, polyester-based resin, for example, polyethyleneterephthalate or polyethylenenaphthalate, polyamide-based resin, for example, various types of nylons, polyimide-based resin, polyamidoimide-based resin, polyarylphthalate-based resin, silicone-based resin, polysulfone-based resin, polyphenylene sulfide-based resin, polyethersulfone-based resin, polyurethane-based resin, acetal-based resin, and cellulose-based resin. Of these resin sheets, it is preferable to use sheets of fluorine-based resins such as polytetrafluoroethylene (PTFE), polyvinylidene fluoride (PVDF), polyvinyl fluoride (PVF), and a copolymer (ETFE) of tetrafluoroethylene and ethylene or propylene, a cyclic polyolefin-based resin, a polycarbonate-based resin, a poly(meth)acrylic resin, polyamide-based resin, and polyester-based resin. Note that it is possible to one of these resins, or to use an arbitrary combination of two or more types thereof at an arbitrary ratio.

A metal material can also be used as the reverse surface protection sheet. Examples are an aluminum foil, aluminum plate, thin stainless steel film, and steel plate. Corrosion prevention is preferably performed on these metal materials. Note that it is possible to use one type of the above-mentioned metals, or to use an arbitrary combination of two or more types thereof at an arbitrary ratio. Furthermore, a composite material of a rein and metal can be used. For example, it is possible to use a high-water-resistant sheet obtained by adhering a fluorine-based resin film on the two surfaces of an aluminum foil. Examples of the fluorine-based resin are ethylene monofluoride (Tedlar^{®} manufactured by Du Pont), polytetrafluoroethylene (PTFE), a copolymer (ETFE) of tetrafluoroethylene and ethylene or propylene, a vinylidene fluoride-based resin (PVDF), and a vinyl fluoride-based resin (PVF). Note that it is possible to use one type of these fluorine-based resins, or to use an arbitrary combination of two or more types thereof at an arbitrary ratio.

It is also possible to give the reverse surface protection sheet functions such as UV blocking, heat radiation blocking, stain resistance, hydrophilic nature, hydrophobic nature, defogging properties, abrasion resistance, conductivity, anti-reflection properties, anti-glare properties, light diffusion, light scattering, wavelength conversion, and gas barrier properties. It is particularly favorable to form a gas barrier layer by using an inorganic oxide deposited layer, from the viewpoint of the moisture barrier properties. The film thickness of the reverse surface protection sheet is normally 20 µm or more, preferably 50 µm or more, and more preferably 100 µm or more, and is normally 1,000 µm or less, preferably 500 µm or less, and more preferably 300 µm or less.

### [G Solar Cell Module Manufacturing Method]

A method of manufacturing the solar cell module of this embodiment is not limited. The following manufacturing procedure is an example.

Step 1: One solar cell element (A) or two or more series- or parallel-connected solar cell elements (A) are formed on substrate (C).
Step 2: A laminate is manufactured by laminating one or a plurality of corrosion-resistant layers (E) on layer (D) containing a scavenger for absorbing water and/or oxygen.
Step 3: On solar cell element (A) on substrate (C) manufactured in step 1, the laminate of layer (D) containing a scavenger and corrosion-resistant layer (E) manufactured in step 2 and gas barrier film (B) are laminated in the order of at least substrate (C), solar cell element (A), corrosion-resistant layer (E), layer (D) containing a scavenger, and gas barrier film (B).

Another favorable example of the manufacturing procedure is as follows.

Step 1: One solar cell element (A) or two or more series- or parallel-connected solar cell elements (A) are formed on substrate (C).

Step 2': A laminate is manufactured by laminating gas barrier film (B), layer (D) containing a scavenger for absorbing water and/or oxygen, and one or a plurality of corrosion-resistant layers (E).

Step 3': On solar cell element (A) on substrate (C) manufactured in step 1, the laminate of gas barrier film (B), layer (D) containing a scavenger, and corrosion-resistant layer (E) manufactured in step 2' is laminated in the order of at least substrate (C), solar cell element (A), corrosion-resistant layer (E), layer (D) containing a scavenger, and gas barrier film (B).

Other layers such as the encapsulating member, weather-resistant protection sheet, and reverse surface protection sheet explained above can be laminated on substrate (C) and/or gas barrier film (B) either before or after steps 1 to 3 or steps 1 to 3' described above are performed.

Although the order of the other layers is not particularly limited, preferable orders when substrate (C) is the light receiving surface are: the order of the reverse surface protection sheet, gas barrier film (B), the encapsulating member, substrate (C), solar cell element (A), layer (D) containing a scavenger for absorbing water and/or oxygen, gas barrier film (B), the encapsulating member, and the reverse surface protection sheet; or the order of the weather-resistant protection sheet, the encapsulating member, the gas barrier film, substrate (C), solar cell element (A), layer (D) containing a scavenger for absorbing water and/or oxygen, gas barrier film (B), the encapsulating member, and the reverse surface protection sheet. When gas barrier film (B) is the light receiving surface, a preferable order is the order of the reverse surface protection sheet, the encapsulating member, substrate (C), solar cell element (A), layer (D) containing a scavenger for absorbing water and/or oxygen, gas barrier film (B), the encapsulating member, and the weather-resistant protection sheet. It is possible to appropriately laminate a plurality of layers as the above-mentioned layers, omit the above-mentioned layers, or insert another functional layer, as needed.

A laminating method is not particularly limited as long as the effect of the present invention is not spoiled. Examples are lamination using an adhesive, heat sealing by melt adhesion, extrusion lamination, co-extrusion molding, a wet film formation of forming a coating film, lamination using a vacuum laminator, lamination using an adhesive, heat sealing by heating or heat pressing, and a wet film formation method using a coater. Among other methods, lamination using a photo-curing adhesive giving actual results in organic EL device encapsulation and lamination using a vacuum laminator giving actual results in solar cells are favorable because versatile apparatuses can be used.

Although the edges of the solar cell module are preferably sealed with the sealing member, the layers to be adhered are not particularly limited as long as the gas barrier properties are held. Examples of a combination to be adhered by the sealing agent are gas barrier film (B) and substrate (C), gas barrier films if a plurality of layers are used as gas barrier films, gas barrier film (B) and the reverse surface protection sheet, substrate (C) and the weather-resistant protection sheet, and the weather-resistant protection sheet and reverse surface protection sheet. The edges of one or more of these combinations or the edges of all layers are sealed. To maintain the gas barrier properties, it is favorable to seal the edges of the gas barrier film and substrate, or the edges of the gas barrier films. To increase the strength of the whole device, it is favorable to seal the edges of the weather-resistant protection sheet and reverse surface protection sheet, or the edges of all layers.

A step of sealing the edges with the sealing agent can properly be selected in accordance with layers to be adhered, the type of sealing agent, and the like. For example, it is possible to seal the edges either after or at the same time the solar cell module constituent layers are laminated. To simplify the manufacturing steps, the edges are preferably sealed simultaneously with lamination.

### [Examples]

### [Making of Gas Barrier Film Using Modified Polyvinyl Alcohol as Weather-Resistant Coating Layer

### <Example A1>

A 12-µm thick biaxially stretched polyethylenenaphthalate film ("Q51C12" manufactured by Teijin Du Pont) was used as a substrate film, and a 0.1-µm thick coating layer was formed on a corona-treated surface of the film by applying and drying the following coating solution. Then, a thin SiOₓ (x = 1.4) film having a thickness of 50 nm was formed on the coating layer by evaporating SiO by a high-frequency heating method in a vacuum at 6.67 × 10⁻⁴ Pa (5 × 10⁻⁶ Torr) by using a vacuum deposition apparatus, thereby obtaining a gas barrier film.

Coating solution: "S-LEC BL-1" (butyralization degree = 63 ± 3 mol%) manufactured by SEKISUI CHEMICAL was used as a polyvinyl butyral resin, and an epoxy resin (°'Denacol EX252" manufactured by Nagase ChemteX) was mixed as a crosslinking agent such that the equivalent of an epoxy group to a hydroxyl group was 1 : 1.

### <Example A2>

A gas barrier film was obtained following the same procedure as in Example A1 except that the coating solution was changed to the following contents. A resin formed as follows was used instead of the polyvinyl butyral resin of Example 1. 250 g of "POVAL Pea-117" (saponification degree = 98.0 to 99.0 mol%, polymerization degree = 1,700) as a polyvinyl alcohol resin manufactured by KURARAY were added to 2,400 g of ion exchanged water and dissolved by heating, 18 g of 35% hydrochloric acid were added to the obtained aqueous solution, and 140 g of butyl aldehyde were dropped while the solution was stirred at 15°C, thereby depositing resin grains. Then, the solution was heated to 50°C while 150 g of 35% hydrochloric acid were dropped under stirring, and held for 2 hrs. After that, the solution was cooled, neutralized by sodium hydrogen carbonate, washed with water, and dried, thereby obtaining a polyvinyl butyral resin powder (butyralization degree = 70 mol %, isotactic triad type residual hydroxyl group amount = 0.1 mol%). In addition, an isocyanate resin ("Sumijule N-3200" manufactured by Sumitomo Bayer Urethane) was mixed as a crosslinking agent such that the equivalent of an epoxy group to a hydroxyl group was 1 : 1.

### <Example A3>

A gas barrier film was obtained following the same procedure as in Example A1 except that the coating solution was changed to the following contents. "KS-3" (acetalization degree = 74 ± 3 mol%) manufactured by SEKISUI CHEMICAL was used as a polyvinyl acetoacetal resin, and "Uban 225" as a melamine resin manufactured by Mitsui Chemicals was mixed as a crosslinking agent such that the equivalent of a melamine group to a hydroxyl group was 1 : 1.

### <Example A4>

A gas barrier film was obtained following the same procedure as in Example A1 except that the coating solution was changed to the following contents. A resin formed as follows was used as a polyvinyl acetoacetal resin. 220 g of "Gohsenol" (saponification degree = 97.0 to 98.8 mol%, polymerization degree = 2,400) as a polyvinyl alcohol resin manufactured by Nippon Synthetic Chemical were added to 2,810 g of ion exchanged water and dissolved by heating, and 645 g of 35% hydrochloric acid were added to the obtained aqueous solution under stirring at 20°C. Then, 3.6 g of butyl aldehyde were added under stirring at 10°C. After 5 min, 143 g of acetoaldehyde were dropped under stirring, thereby depositing resin grains. Subsequently, after being held at 60°C for 2 hrs, the solution was cooled, neutralized by sodium hydrogen carbonate, washed with water, and dried, thereby obtaining a polyvinyl acetoacetal resin powder (acetalization degree = 75 mo%). In addition, an isocyanate resin ("Sumijule N-3200" manufactured by Sumitomo Bayer Urethane) was mixed as a crosslinking agent such that the equivalent of an epoxy group to a hydroxyl group was 1 : 1.

### <Example A5>

The surface of the thin inorganic film as a gas barrier film of Example A2 was coated with an aqueous ammonium salt solution of a copolymer (mass ratio = 25 : 75) of methacrylic acid and butyl methacrylate, and the solution was dried, thereby forming a 0.3-µm thick protective layer.

### <Example A6>

On the surface of the thin inorganic film as a gas barrier film of Example A2, a 20-nm SiOₓN_{y} (x = 1.6, y = 0.2) film was deposited as a plasma CVD film by using a plasma CVD apparatus by applying 1 kW by using a 13.56-MHz, high-frequency discharge plasma source in a vacuum at 10.7 Pa (8 × 10⁻² Torr) by using tetraethoxysilane as a material and oxygen, nitrogen, and argon as reaction gases. Then, a vacuum deposition film was deposited on the plasma CVD film surface in the same manner as in Example A1, thereby obtaining a gas barrier film including three thin inorganic films.

### <comparative Example A1>

A gas barrier film was obtained following the same procedure as in Example A1 except that the coating solution was changed to the following contents. As a coating solution, an isocyanate compound ("CORONATE L" manufactured by NIPPON POLYURETHANE) and saturated polyester ("VYLON 300" manufactured by TOYOBO) were mixed at a weight ratio of 1 : 1.

### <Comparative Example A2>

A gas barrier film was obtained following the same procedure as in Example A1 except that the coating solution was changed to the following contents. As a coating solution, "Takelac UA-902" as acrylpolyol manufactured by Mitsui Chemical Urethane, tolylenediisocyanate (TDI) as aromatic isocyanate, and "Cosmonate 80" manufactured by Mitsui Chemical Urethane were mixed such that the equivalent of an isocyanate value to a hydroxyl value was 1 : 1.

### <Comparative Example A3>

A gas barrier film was obtained following the same procedure as in Example A1 except that the coating solution was changed to the following contents. As a coating solution, "PESRESIN A-120" as a polyester resin manufactured by Takamatsu Oil & Fat and "JDX-6500" as an acrylic resin manufactured by Johnson Polymer were mixed at a solid content ratio of 1 : 1.

### <Comparative Example A4>

A gas barrier film was obtained following the same procedure as in Example A1 except that the coating solution was changed to the following contents. As a coating solution, "S-LEC BL-1" (butyralization degree = 63 ± 3 mol%) as a polyvinyl butyral resin manufactured by SEKISUI CHEMICAL was used.

[Making of Gas Barrier Film Using At Least One of Polycaprolactone Polyol and Polycarbonate Polyol as Weather-Resistant Coating Layer]

### <Example B1

A 12-µm thick biaxially stretched polyethylenenaphthalate film ("Q51C12" manufactured by Teijin Du Pont) was used as a substrate film, and a 0.1-µm thick coating layer was formed on a corona-treated surface of the film by applying and drying the following coating solution. Then, a thin SiOₓ (x = 1.4) film having a thickness of 50 nm was formed on the coating layer by evaporating SiO by a high-frequency heating method in a vacuum at 6.67 × 10⁻⁴ Pa (5 × 10⁻⁶ Torr) by using a vacuum deposition apparatus, thereby obtaining a gas barrier film.

Coating solution: "PLACCEL 205" as polycaprolactone diol manufactured by DAICEL CHEMICAL and "Denacol EX252" as an epoxy resin manufactured by Nagase ChemteX were mixed such that the equivalent ratio of an epoxy group to a hydroxyl group was 1 : 2.

### <Example B2>

A gas barrier film was obtained following the same procedure as in Example B1 except that the coating solution was changed to the following solution. "PLACCEL 220" as polycaprolactone diol manufactured by DAICEL CHEMICAL and "Sumijule N-3200" as an isocyanate resin manufactured by Sumitomo Bayer Urethane were mixed such that the equivalent ratio of an isocyanate group to a hydroxyl group was 1 : 1.

### <Example B3>

A gas barrier film was obtained following the same procedure as in Example B1 except that the coating solution was changed to the following solution. "NIPPPOLAN 982R" as polycarbonate diol manufactured by NIPPON POLYURETHANE and "CORONATE L" as an isocyanate resin manufactured by NIPPON POLYURETHANE were mixed such that the equivalent ratio of an isocyanate group to a hydroxyl group was 1 : 1.

### <Example B4>

A gas barrier film was obtained following the same procedure as in Example B1 except that the coating solution was changed to the following solution. "PLACCEL CD CD210" as polycarbonate diol manufactured by DAICEL CHEMICAL and "Takenate D-170HN" as an isocyanate resin manufactured by Mitsui Chemical Polyurethane were mixed such that the equivalent ratio of an isocyanate group to a hydroxyl group was 1 : 1.

### <Comparative Examples B1, B2, & B3>

Gas barrier films were respectively obtained following the same procedures as in Comparative Examples A1, A2, and A3 described above.

### <Comparative Example B4>

A gas barrier film was obtained following the same procedure as in Example B1 except that the coating solution was changed to the following solution. "Adeka Newace Y4-5" as adipate-based polyester polyol manufactured by ADEKA and "Sumijule N-3200" as an isocyanate resin manufactured by Sumitomo Bayer Urethane were mixed such that the equivalent ratio of an isocyanate group to a hydroxyl group was 1 : 2.

### <Comparative Example B5>

A gas barrier film was obtained following the same procedure as in Example B1 except that the coating solution was changed to the following solution. "Desmophene 550U" as polyether polyol manufactured by Sumitomo Bayer Urethane and "Sumijule N-3200" as an isocyanate resin manufactured by Sumitomo Bayer Urethane were mixed such that the equivalent ratio of an isocyanate group to a hydroxyl group was 1 : 2.

### [Making of Gas Barrier Film Using Acrylic Copolymer as Weather-Resistant Coating Layer]

### <Example C1>

A 12-µm thick biaxially stretched polyethylenenaphthalate film ("Q51C12" manufactured by Teijin Du Pont) was used as a substrate film, and a 0.1-µm thick coating layer was formed on a corona-treated surface of the film by applying and drying the following coating solution. Then, a thin gas barrier film including a thin SiOₓ (x = 1.7) film having a thickness of 20 nm was formed on the coating layer by evaporating SiO by a high-frequency heating method in a vacuum at 1.33 × 10⁻³ Pa (1 × 10⁻⁵ Torr) by using a vacuum deposition apparatus.

Coating solution: 100 parts by weight of ethyl acetate were placed under a nitrogen gas stream in a four neck flask including a stirrer, thermometer, cooler, and nitrogen gas supply pipe, and heated to 80°C. A mixture containing a material made of polymerizable monomer components shown in Table 1-1-1 and 1 part by weight of benzoyl peroxide was dropped in ethyl acetate in the flask over 2 hrs. In addition, the resultant solution was held at 80°C for 4 hrs, thereby obtaining a 50-mass% solution of an acrylic copolymer. Subsequently, an epoxy-based copolymer ("Deconal EX622" manufactured by Nagase ChemteX) was mixed in this acrylic resin solution such that the equivalent ratio of an epoxy group to a carboxyl group was 1 : 1.

### <Examples C2 - C12>

Gas barrier films were obtained following the same procedure as in Example C1 except that acrylic copolymer solutions were prepared by using materials made of polymerizable monomer components shown in Tables 1-1-1 and 1-1-2, and an isocyanate resin ("Sumijule N-3200" manufactured by Sumitomo Bayer Urethane) were mixed in the acrylic copolymer solutions such that the equivalent ratio of an isocyanate group to a hydroxyl group was 1 : 1.

### <Comparative Examples C1, C2, & C3>

Gas barrier films were respectively obtained by following the same procedures as in Comparative Examples A1, A2, and A3 described above.

### <Comparative Example C4>

A gas barrier film was obtained by preparing a coating solution in the same manner as in Example 2 except that the material monomers of the acrylic copolymer solution were changed as shown in Table 1-2.

### <Comparative Example C5>

An acrylic resin solution was prepared by excluding monomers a-1 and b-2 from the material monomers of Example C10, and adding 2 mass%, as a resin solid component ratio, of "TINUVIN 123" as a hindered amine-based UV stabilizer (HALS) manufactured by Ciba Specialty Chemicals, and 35 mass%, as a resin solid component ratio, of "TINUVIN PS" as a benzotriazole-based UV absorbent (UVA) manufactured by Ciba Specialty Chemicals. Then, a gas barrier film was obtained following the same procedure as in Example C1 except that an isocyanate resin ("Sumijule N-3200" manufactured by Sumitomo Bayer Urethane) were mixed in this acrylic resin solution such that the equivalent of an isocyanate group to a hydroxyl group was 1 : 1.

### <Comparative Example C6>

An ethylacrylate/methylmethacrylate/itaconic acid/p-styrene sulfonic acid copolymer (molar ratio = 37.5 : 37.5 : 10 : 15) was formed by emulsion polymerization by using an aqueous solution prepared by dissolving 67.5 ml of ethylacrylate, 66.4 ml of methylmethacrylate, 21.3 g of itaconic acid, and 51 g of p-styrene sodium sulfonate in 250 ml of ion exchanged water, an aqueous solution prepared by dissolving 8 ml of dodecylbenzene sodium sulfonate in 100 ml of water, an aqueous solution prepared by dissolving 2 g of ammonium sulfate, in 20 ml of water, and 505 ml of ion exchanged water. A gas barrier film was obtained following the same procedure as in Example C1 except that 3 mass% of the above-mentioned acrylic copolymer, 0.03% of "Synperonic NP10" as a surfactant manufactured by ICI, 0.3% of "CYMEL 300" as a melamine-based crosslinking compound manufactured by Mitsui Cytec, and 0.03% of a 10% aqueous solution of p-toluene ammonium sulfonate were mixed.

**Table 1-1-1**

| | | | Examples | | | | | | | | | | | |
|---|---|---|---|---|---|---|---|---|---|---|---|---|---|---|
| | | | C1 | | C2 | | C3 | | C4 | | C5 | | C6 | |
| Acrylic copolymer materials | (Polymerizable UV-stable monomer | Type | a-1 | | a-2 | | a-2 | | a-1 | | a-1 | | | |
| | | Part by mass | | 5.0 | | 5.0 | | 2.0 | | 3.0 | | 0.5 | | 0.0 |
| | Polymerizable UV-absorbing monomer | Type | | | | | b-1 | | b-2 | | | | | |
| | | Part by mass | | 0.0 | | 0.0 | | 4.0 | | 1.0 | | 0.0 | | 0.0 |
| | Cycloalkyl(meth)-acrylate | Type | c-1 | | c-1 | | c-1 | | c-1 | | c-1 | | c-1 | |
| | | Part by mass | | 40.0 | | 30.0 | | 30.0 | | 40.0 | | 30.0 | | 30.0 |
| | | Type | | | c-2 | | c-2 | | | | | | | |
| | | Part by mass | | | | 26.0 | | 25.0 | | | | | | |
| | unsaturated monomer having hydroxyl group | Type | d-1 | | d-2 | | d-2 | | d-2 | | d-2 | | d-2 | |
| | | Part by mass | | 10.0 | | 18.0 | | 18.0 | | 5.0 | | 10.0 | | 10.0 |
| | Polymerizable unsaturated monomer | Type | e-1 | | | | | | e-1 | | e-1 | | e-1 | |
| | | Part by mass | | 20.0 | | | | | | 20.0 | | 20.0 | | 20.0 |
| | | Type | e-2 | | e-2 | | e-2 | | e-2 | | e-2 | | e-2 | |
| | | Part by mass | | 24.0 | | 20.0 | | 20.0 | | 30.5 | | 39.0 | | 39.5 |
| | | Type | e-6 | | e-6 | | e-6 | | e-6 | | e-6 | | e-6 | |
| | | Part by mass | | 1.0 | | 1.0 | | 1.0 | | 0.5 | | 0.5 | | 0.5 |
| Crosslinking compound | | | Epoxy | | Isocyanate | | Isocyanate | | Isocyanate | | Isocyanate | | Isocyanate | |

**Table 1-1-2**

| | | | Examples | | | | | | | | | | | |
|---|---|---|---|---|---|---|---|---|---|---|---|---|---|---|
| | | | C7 | | C8 | | C9 | | C10 | | C11 | | C12 | |
| Acrylic copolymer materials | Polymerizable UV-stable monomer | Type | a-1 | | | | a-1 | | a-1 | | a-3 | | a-2 | |
| | | Part by mass | | 1.0 | | 0.0 | | 3.0 | | 2.0 | | 2.0 | | 2.0 |
| | Polymerizable UV-absorbing monomer | Type | b-2 | | b-2 | | b-3 | | b-2 | | b-3 | | b-1 | |
| | | Part by mass | | 0.5 | | 30.0 | | 50.0 | | 35.0 | | 20.0 | | 4.0 |
| | Cycloalkyl(meth)-acrylate | Type | c-1 | | c-1 | | | | c-1 | | c-1 | | c-1 | |
| | | Part by mass | | 30.0 | | 30.0 | | 0.0 | | 30.0 | | 50.0 | | 30.0 |
| | | Type | | | | | | | | | | | c-2 | |
| | | Part by mass | | | | | | | | | | | | 25.0 |
| | Polymerizable unsaturated monomer having hydroxyl group | Type | d-2 | | d-2 | | d-2 | | d-2 | | d-2 | | | |
| | | Part by mass | | 2.0 | | 10.0 | | 10.0 | | 5.0 | | 5.0 | | |
| | Polymerizable unsaturated monomer | Type | e-1 | | e-3 | | e-3 | | | | | | | |
| | | Part by mass | | 26.0 | | 30.0 | | 32.0 | | | | | | |
| | | Type | e-2 | | | | e-4 | | e-2 | | e-2 | | e-2 | |
| | | Part by mass | | 40.0 | | | | 5.0 | | 28.0 | | 23.0 | | 20.0 |
| | | Type | e-6 | | | | | | | | | | e-6 | |
| | | Part by mass | | 0.5 | | 0.0 | | 0.0 | | 0.0 | | 0.0 | | 1.0 |
| Crosslinking compound | | | Isocyanate | | Isocyanate | | Isocyanate | | Isocyanate | | Isocyanate | | | |

**[Table 1-2]**

| | | | Comparative Examples | | | | | | | | |
|---|---|---|---|---|---|---|---|---|---|---|---|
| | | | C1 | C2 | C3 | C4 | | C5 | | C6 | |
| Acrylic copolymer materials | Polymerizable UV-stable monomer | Type | | | | | | | | | |
| | | Part by mass | | | | | | | | | |
| | Polymerizable UV-absorbing monomer | Type | | | | | | | | | |
| | | Part by mass | | | | | | | | | |
| | Cycloalkyl(meth)-acrylate | Type | | | | | | c-1 | | | |
| | | Part by mass | | | | | | | 30.0 | | |
| | Polymerizable unsaturated monomer having hydroxyl group | Type | | | | d-2 | | d-2 | | | |
| | | Part by mass | | | | | 19.0 | | 5.0 | | |
| | Polymerizable unsaturated monomer | Type | | | | e-1 | | | | e-4 | |
| | | Part by mass | | | | | 40.0 | | | | 32.2 |
| | | Type | | | | e-2 | | e-2 | | e-5 | |
| | | Part by mass | | | | | 40.0 | | 28.0 | | 32.7 |
| | | Type | | | | e-6 | | | | e-7 | |
| | | Part by mass | | | | | 1.0 | | | | 10.3 |
| | | Type | | | | | | | | e-8 | |
| | | Part by mass | | | | | | | | | 24.7 |
| Other resins | | | Saturated polyester | Acrylic copolymer | Acrylic resin + polyester | | | HALS+ UVA | | | |
| Crosslinking compound | | | Isocyanate | Isocyanate | | Isocyanate | | Isocyanate | | Melamine | |

Monomers used in Examples C1 to C12 and Comparative Examples C1 to C6 described above are as follows.

(Polymerizable UV-stable Monomers)
a-1: 4-methacryloyloxy-2,2,6,6-tetramethylpiperidine
a-2: 4-methacryloyloxy-2,2,6,6-pentamethylpiperidine
a-3: 1-methacryloyl-4-methacryloylamino-2,2,6,6-tetramethylpiperidine

### (Polymerizable UV-absorbing Monomers)

b-1: 2-hydroxy-4-(3-methacryloyloxy-2-hydroxypropoxy)benzophenone
b-2: 2-[2'-hydroxy-5'-(methacryloyloxyethyl)phenyl]-2H-benzotriazole
b-3: 2-[2'-hydroxy-5'-(B-methacryloyloxyethoxy)-3'-t-butylphenyl]-4-t-butyl-2H-benzotriazole(cycloalkyl(meth)acrylate)
c-1: cyclohexylmethacrylate
c-2: t-butylcyclohexylmethacrylate (Polymerizable Unsaturated Monomer Having a Hydroxyl Group)
d-1: hydroxypropylacrylate
d-2: hydroxyethylmethacrylate

### (Other Polymerizable Unsaturated Monomers)

e-1: n-butylmethacrylate
e-2: n-butylacrylate
e-3: 2-ethylhexylacrylate
e-4: methylmethacrylate
e-5: ethylacrylate
e-6: methacrylic acid
e-7: itaconic acid
e-8: p-toluene sulfonic acid

### <Gas Barrier Film Evaluation Method>

The gas barrier film of each example described above was evaluated. More specifically, as will be described below, a solar cell module including a gas barrier film was formed following the same procedure as for an actual solar cell module, and exposed to a high temperature and high humidity, and the water vapor transmission rate was measured after that.

### <Making of Evaluation Samples>

A gas barrier film/encapsulating sheet/glass were laminated in this order, and lamination was performed using a vacuum laminator with a separator film being sandwiched in a central portion between the encapsulating sheet and gas barrier film. More specifically, a 0.5-mm, thick ethylene vinyl acetate resin as an ethylene-based copolymer was used as the encapsulating sheet. By using the separator film, encapsulating sheet, and glass plate, lamination was performed at a hotplate temperature of 150°C for a vacuum time of 5 min and a pressing time of 8 min by using a solar cell module manufacturing laminator (LM-50 X50-S manufactured by NPC).

The obtained laminate was stored at 85°C and 85 RH% for 0 or 1,000 hrs, and a gas barrier film was cut out from the separator film area portion. The gas barrier film was then dried with air at room temperature for two days, and adhered to an unstretched polypropylene film ("Pylen Film-CT P1146" manufactured by TOYOBO, thickness = 50 µm) by using two-pack adhesives ("DYNAGRAND IS-063" and "DYNAGRAND LCR-085" manufactured by TOYO INK, thickness = 5 µm), The obtained gas barrier film was used in water vapor transmission rate measurement.

### <Water Vapor Transmission Rate Measurement: Gravimetry>

Based on the conditions of JIS Z0222 "Moisture Transmission Rate Testing Method for Moistureproof Packaging Container" and JIS Z0208 "Moisture Transmission Rate Testing Method (Cup Method) for Moistureproof Packaging Material", a bag containing about 20 g of anhydrous calcium chloride as a moisture absorbent was formed by sealing the four sides of two square sheets having a moisture transmission area of 10 cm × 10 cm, and placed in a thermo-hygrostat at a temperature of 40°C and a relative humidity of 90%. Mass measurement (unit = 0.1 mg) was performed at an interval of 72 hrs or more until 30 days by assuming that the mass increase became almost constant, and the water vapor transmission rate (g/m²/24 h) was obtained from the average value of the moisture absorption weight increase ratios.

The results of measurements performed in accordance with the above method are as follows.

**Table 2-1**

| | Example A1 | Example A2 | Example A3 | Example A4 | Example A5 | Example A6 |
|---|---|---|---|---|---|---|
| Weather-resistant coat | Polyvinyl-butyral + epoxy | Polyvinyl-butyral + isocyanate | Polyvinyl-acetoacetal + melamine | Polyvinyl- acetoacetal + isocyanate | Polyvinyl- butyral + isocyanate | Polyvinyl-butyral + isocyanate |
| Water vapor transmission rate (g/m²/day) 85°C85RH%Ohr | 0.05 | 0.03 | 0.05 | 0.02 | 0.02 | <0.01 |
| Water vapor transmission rate (g/m²/day) 85°C85RH%1000hr | 0.07 | 0.03 | 0.07 | 0.02 | 0.02 | <0.01 |

**Table 2-2**

| | Comparative Example A1 | Comparative Example A2 | Comparative Example A3 | Comparative Example A4 |
|---|---|---|---|---|
| Weather-resistant coat | Polyester + isocyanate | Acrylpolyol + isocyanate | Polyester + acryl | Polyvinyl-butyral |
| Water vapor transmission rate (g/m²/day) 85°C85RH%0hr | 0.08 | 0.08 | 0.5 | 0.5 |
| Water vapor transmission rate (g/m²/day) 85°C85RH%1000hr | >1 | >1 | >1 | >1 |

**Table 3-1**

| | Example B1 | Example B2 | Example B3 | Example B4 |
|---|---|---|---|---|
| Weather-resistant coat | Polycaprolactone-diol + epoxy | Polycaprolactone-diol + isocyanate | Polycarbonate-diol + isocyanate | Polycarbonate- diol + isocyanate |
| Water vapor transmission rate (g/m²/day) 85°C85RH%0hr | 0.1 | 0.1 | 0.2 | 0.2 |
| Water vapor transmission rate (g/m²/day) 85°C85RH%1000hr | 0.1 | 0.1 | 0.2 | 0.2 |

**Table 3-2**

| | Comparative Example B1 | Comparative Example B2 | Comparative Example B3 | Comparative Example B4 | Comparative Example B5 |
|---|---|---|---|---|---|
| Weather-resistant coat | Polyester + isocyanate | Acrylpolyol + isocyanate | Polyester + acryl | Polyester adipate polyol + isocyanate | Polyether-polyol + isocyanate |
| Water vapor transmission rate (g/m²/day) 85°C85RH%0hr | 0.08 | 0.08 | 0.5 | 0.2 | 0.8 |
| Water vapor transmission rate (g/m²/day) 85°C85RH%1000hr | >1 | >1 | >1 | >1 | >1 |

**Table 4-1**

| | Example C1 | Example C2 | Example C3 | Example C4 | Example C5 | Example C6 | Example C7 | Example C8 | Example C9 | Example C10 |
|---|---|---|---|---|---|---|---|---|---|---|
| Water vapor transmission rate (g/m²/day) 85°C85RH%0hr | 0.05 | 0.02 | <0.01 | <0.01 | 0.02 | 0.03 | <0.01 | 0.02 | 0.03 | <0.01 |
| Water vapor transmission rate (g/m²/day) 85°C85RH%1000hr | 0.05 | 0.02 | <0.01 | <0.01 | 0.02 | 0.03 | <0.01 | 0.02 | 0.03 | <0.01 |

**Table 4-2**

| | Example C11 | Example C12 | Comparative Example C1 | Comparative Example C2 | Comparative Example C3 | Comparative Example C4 | Comparative Example C5 | Comparative Example C6 |
|---|---|---|---|---|---|---|---|---|
| Water vapor transmission rate (g/m²/day) 85°C85RH%0hr | <0.01 | <0.01 | 0.08 | 0.08 | 0.5 | 0.08 | 0.2 | 0.7 |
| Water vapor transmission rate (g/m²/day) 85°C85RH°s1000hr | <0.01 | <0.01 | >1 | >1 | >1 | >1 | >1 | >1 |

### <Water Vapor Transmission Rate Measurement: Differential Pressure Method>

Water vapor transmission rate measurement was performed by using a differential pressure method on each gas barrier film whose water vapor transmission rate was less than 0.01 g/m²/day when measured using gravimetry.
This water vapor transmission rate measurement using the differential pressure method was performed by using Deltaperm manufactured by Technolox. In this apparatus, the gas barrier film is sandwiched between upper and lower chambers, and water vapor transmission from the upper chamber under humidified conditions to the lower chamber under vacuum conditions is measured by sensing the pressure change. The water vapor transmission rate (g/m²/day) was obtained by subtracting a measurement value when both the upper and lower chambers were at 40°C and 0 RH% from a measurement value when the upper chamber was at 40°C and 90 RH% and the lower chamber was at 40°C and 0 RH%.

### [Making of CIGS Solar Cell Element]

A thin polycrystalline CIGS film was grown by the three-stage process by using an MBE apparatus. As a substrate, a soda-lime glass (SLG) substrate on which molybdenum (Mo) was deposited by 1.5 to 2.0 µm by sputtering was used. First, the molecular beam epitaxy deposition apparatus was used to deposit an indium-gallium-selenium (In-Ga-Se) precursor (the composition ratio of In-Ga-Se was In : Ga : Se = 2(1 - x) : 2x : 3 (0 < x ≤ 1)) on the substrate at a substrate temperature of about 350°C so that the film thickness was 1.8 to 2.3 µm (the first stage). Then, the substrate temperature was raised to 550°C, and the same molecular beam epitaxy deposition apparatus was used to perform Cu-Se irradiation until the substrate temperature decreased by about 1°C while monitoring the substrate temperature, thereby forming a thin Cu-rich Cu(In₁₋ₓGaₓ) Se₂(CIGS) film (the second stage). The film thickness was 2.0 to 2.5 µm at the end of the second stage. Finally, the molecular beam epitaxy deposition apparatus was used again to start In-Ga-Se irradiation while the substrate temperature was held at 550°C. After the substrate temperature took a minimal value after the irradiation, the irradiation was continued until the temperature rose by about 1°C, thereby forming a thin polycrystalline CIGS film in which the group III was slightly excessive. The final film thickness of the thin CIGS film was 2.0 to 2.5 µm.

The composition of the thin CIGS film was found to be CuIn_{0.97}Ga_{0.32}Se_{2.63} by EDX analysis. A CIGS solar cell element including aluminum (Al)/zinc oxide (ZnO)/cadmium sulfide (CdS) /CIGS/Mo/SLG having the arrangement as shown in Fig. 1 was manufactured by using the thin polycrystalline CIGS film formed as described above. The thickness of the zinc oxide layer and cadmium sulfide layer was a few ten nm. CdS was formed by the solution growth process, ZnO was formed by MOCVD, and Al was finally deposited as electrodes by vacuum deposition. The cell area was 0.2 cm².

### <Making of CIGS Solar Cell Module>

In the solar cell module of the present invention, it is possible to use any of the gas barrier film using modified polyvinyl alcohol as the weather-resistant coating layer, the gas barrier film using at least one of polycaprolactone polyol and polycarbonate polyol as the weather-resistant coating layer, and the gas barrier film using an acrylic copolymer as the weather-resistant coating layer, which were formed in accordance with the above-mentioned examples. The gas barrier film formed in accordance with the above-mentioned examples has a high protection performance as described above. Accordingly, it should be noted that it is apparent to those skilled in the art that a solar cell module manufactured using any of the gas barrier films formed in accordance with the above-mentioned examples has an environmental resistance, particularly, a high-temperature resistance and high-humidity resistance.

First, solar cell modules of Examples D1 and D2 and Comparative Examples D1 and D2 were manufactured by laminating a gas barrier film/encapsulating sheet/CIGS solar cell element/encapsulating sheet/glass in this order. Note that the gas barrier film had a substrate film surface and thin inorganic film surface, and lamination was performed such that the substrate film surface was positioned on the encapsulating sheet side. As the encapsulating sheet, a 0.5-mm thick ethylene vinyl acetate resin as an ethylene-based copolymer resin was used. As the gas barrier film, different gas barrier films to be described below were used in these examples and comparative examples. In addition, as Reference Example D1, a solar cell module was manufactured by using glass instead of the gas barrier film.

More specifically, by using the encapsulating sheet and glass plate, lamination was performed at a hotplate temperature of 150°C for a vacuum time of 5 min and a pressing time of 8 min by using a solar cell module manufacturing laminator (LM-50 X50-S manufactured by NPC), thereby manufacturing a solar cell module (10 cm × 10 cm). The gas barrier films used in Examples D1 and D2 and Comparative Examples D1 and D2, and the glass used in Reference Example D1 are as follows.

· Example D1 The gas barrier film according to Example D1 was formed by adhering a biaxially stretched polyethyleneterephthalate film (manufactured by Mitsubishi Plastics, thickness = 50 µm) as a protective layer to the inorganic thin film layer of the gas barrier film formed in Example A4 by using two-pack adhesives ("DYNAGRAND IS-063" and "DYNAGRAND LCR-085" manufactured by TOYO INK, thickness = 5 µm).
· Example D2 The gas barrier film was formed following the same procedure as in Example D1 except that the gas barrier film formed in Example C10 was used instead of the gas barrier film formed in Example A4.
· Comparative Example D1 The gas barrier film was formed following the same procedure as in Example D1 except that "Fluon^{®}" as a tetrafluoroethylene-ethylene copolymer (ETFE) film manufactured by Asahi Glass and having a film thickness of 100 µm was used instead of the gas barrier film formed in Example A4.
· Comparative Example D2 The gas barrier film was formed following the same procedure as in Example D1 except that TECHBARRIER VX manufactured by Mitsubishi Plastics and having a film thickness of 12 µm was used instead of the gas barrier film formed in Example A4.
· Reference Example D1 Heat-treated white flat glass (manufactured by AGC Fabritech and having high-transmittance glass embosses for a solar cell, thickness = 3.2 mm) was used, and a solar cell module was manufactured by laminating the heat-treated white flat glass/encapsulating sheet/CIGS solar cell element/encapsulating sheet/glass in this order.

The water vapor transmittance of each of the gas barrier films according to Examples D1 and D2 and Comparative Examples D1 and D2 and the glass according to Reference Example D1 was measured by gravimetry in the same manner as for the gas barrier film of Example A1 (and other examples). Table 5 shows the measurement results.

[Table 5]

**Table 5**

| | Example D1 | Example D2 | Comparative Example D1 | Comparative Example D2 | Reference Example D1 |
|---|---|---|---|---|---|
| Water vapor transmission rate (g/m²/day) 85°C85RH%0hr | 0.02 | <0.01 | >1 | 0.3 | 0 |
| Water vapor transmission rate (g/m²/day) 85°C85RH%1000hr | 0.02 | <0.01 | >1 | >1 | 0 |

When measured by the differential pressure method, the water vapor transmission rate of the gas barrier film according to Example D2 was 0.001 g/m²/day.

### <Evaluation of CIGS Solar Cell Modules>

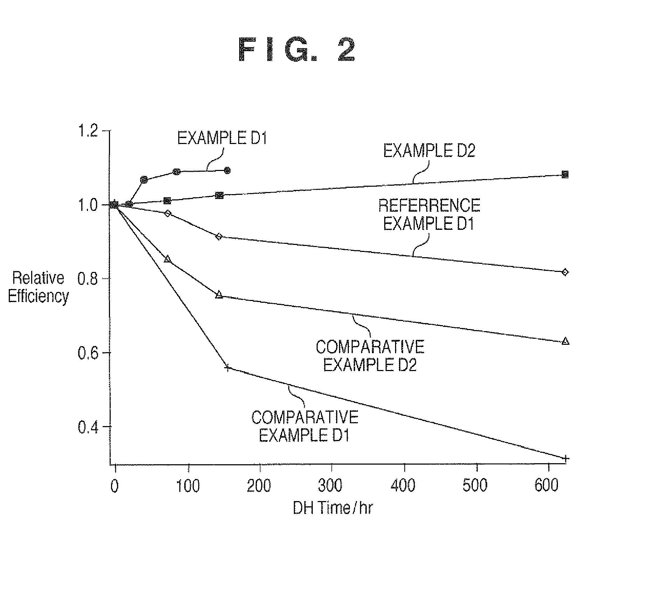

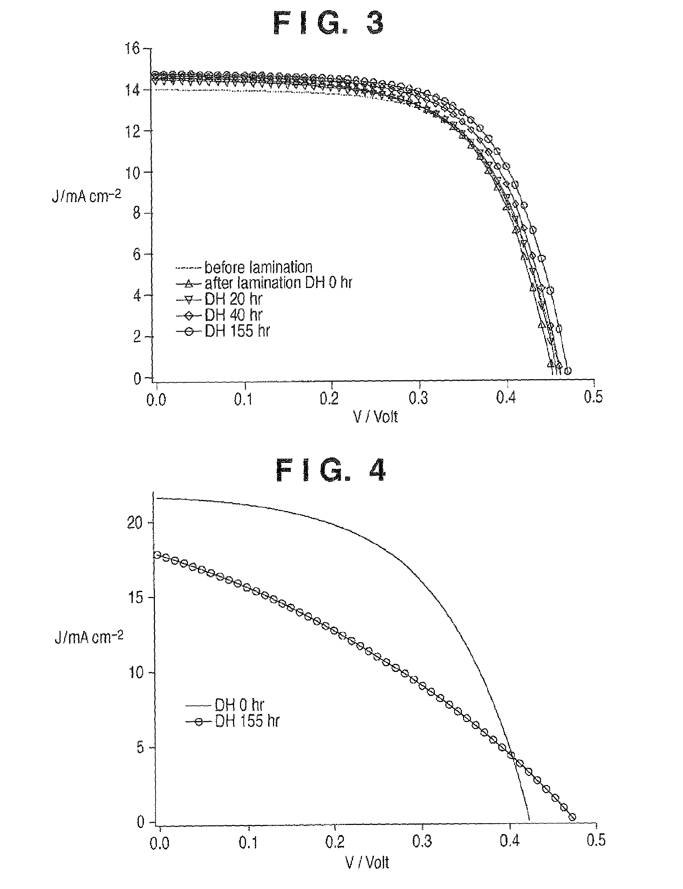

After the current-voltage characteristic was measured at an AM of 1.5, each manufactured solar cell module was exposed to 85°C and 85% RH. After a predetermined exposure time elapsed, the solar cell module was moved to room temperature and room humidity, and the JV characteristic was measured at an AM of 1.5. Tables 6-1 and 6-2 and Fig. 2 show the dependence of the energy conversion efficiency on the exposure time. Fig. 3 shows the dependence of the JV characteristic on the exposure time (DH Time) of Example D1 and Fig. 4 shows that of Comparative Example D1 The energy conversion efficiency is defined by dividing the electrical energy generated by the solar cell module by the energy of light incident on the solar cell module. As shown in Tables 6-1 and 6-2, the power generation efficiency of the solar cell module of the present invention when the module was exposed to air at a temperature of 85°C and a humidity of 85% for 155 hrs was higher than that before the exposure. The total results of Examples D1 and D2 reveal that when the power generation efficiency of the solar cell module of the present invention when the module is exposed to air at a temperature of 85°C and a humidity of 85% for 144 hrs is divided by that before the exposure, the result is 1.03 or more.

[Table 6]

**Table 6-1**

| Example D1 | | Example D2 | |
|---|---|---|---|
| Exposure time (h) | Relative efficiency | Exposure time (h) | Relative efficiency |
| 0 | 1.00 | 0 | 1.00 |
| 20 | 1.00 | 72 | 1.01 |
| 40 | 1.07 | 144 | 1.03 |
| 85 | 1.09 | 624 | 1.08 |
| 155 | 1.09 | | |

**Table 6-2**

| Comparative Example D1 | | Comparative Example D2 | | Reference Example D1 | |
|---|---|---|---|---|---|
| Exposure time (h) | Relative efficiency | Exposure time (h) | Relative efficiency | Exposure time (h) | Relative efficiency |
| 0 | 1.00 | 0 | 1.00 | 0 | 1.00 |
| 155 | 0.56 | 72 | 0.85 | 72 | 0.98 |
| 624 | 0.31 | 144 | 0.75 | 144 | 0.91 |
| | | 624 | 0.63 | 624 | 0.81 |
| | | | | | |

The results shown in Fig. 2 and Tables 6-1 and 6-2 demonstrate that the energy conversion efficiency of each of the solar cell modules of Examples D1 and D2 according to this application did not decrease or rather increased even after the module was exposed to a high temperature and high humidity. By contrast, when using each of the well-known transparent film and gas barrier film of Comparative Examples D1 and D2, the energy conversion efficiency abruptly decreased from the beginning, and further decreased due to deterioration with time. Even when using glass instead of the gas barrier film as in Reference Example D1, the energy conversion efficiency gradually decreased due to deterioration with time.

The water vapor transmission rate of each of the gas barrier films formed by Examples A1 to A6, B1 to B4, and C1 to C12 of the present invention was 0.01 g/m²/day (exclusive) to 0.2 g/m²/day, that is, obviously lower than that of each comparative example. In addition, even when each gas barrier film was left to stand at a high temperature and high humidity for a long time, the change in water vapor transmission rate was evidently smaller than that of each comparative example, that is, the barrier properties against water vapor hardly decreased. It is normally unlikely that the energy conversion efficiency increases after exposure to a high temperature and high humidity as in Examples D1 and D2. However, a low water vapor transmission rate of the gas barrier film according to the present invention as described above is presumably one of the reasons that the energy conversion efficiency increases after exposure to a high temperature and high humidity.

That is, a very slight amount of water transmitted through the gas barrier film according to the present invention probably interacts with the solar cell element, thereby raising the energy conversion efficiency of the solar cell element. For example, the energy conversion efficiency increases perhaps because the recombination center is deactivated. It is also possible that while the gas barrier film according to the present invention transmits almost no water, another element such as heat or light interacts with the solar cell element and increases its energy conversion efficiency. In either case, the use of the gas barrier film according to the present invention having high barrier properties against water vapor and capable of preventing deterioration of the solar cell element makes it possible to prevent deterioration of each part forming the solar cell module of the present invention. Accordingly, the use of the gas barrier film according to the present invention is presumably one important element with which the energy conversion efficiency rises after the solar cell module of the present invention is exposed to a high temperature and high humidity.

### [Making of Organic Thin-film Solar Cell Element]

A glass substrate 510 (sheet resistance = 15 Ω/□ or less) on which a indium-tin oxide (ITO) transparent conductive film was deposited was patterned into stripes having a width of 2 mm by using the conventional photolithography technique and hydrochloric acid etching, thereby forming a transparent electrode. The patterned transparent electrode was cleaned by ultrasonic cleaning using a surfactant, washing using ultrapure water, and ultrasonic cleaning using ultrapure water in this order, blown with nitrogen, and dried by heating at 120°C for 10 min.

This transparent substrate was spin-coated with 40-nm thick poly(ethylenedioxythiophene) : poly(styrene sulfonic acid) (PEDOT : PSS, Baytron PH^{®} manufactured by Starck-V TECH) as a conductive polymer, and dried by heating in the atmosphere at 120°C for 10 min.
After this step, the substrate was placed in a glove box, and processed in a nitrogen ambient.

First, the above-mentioned substrate was heated at 180°C for 3 min in the nitrogen ambient. Then, a solution prepared by dissolving 0.5 wt% of compound (5) below in a 1 : 2 solvent mixture (weight) of chloroform/chlorobenzene was filtered, the above-mentioned PEDOT : PSS film was spin-coated with the solution at 1,500 rpm and heated at 180°C for 20 min, thereby obtaining a film of compound (6) below. Compound (5) was converted into compound (6) by the heating process.

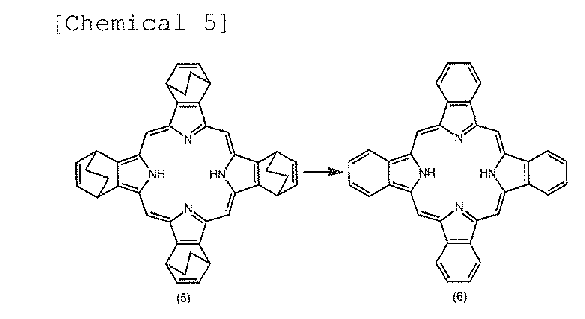

A solution was prepared by dissolving 0.6 wt% of compound (5) in a 1 : 1 solvent mixture (weight) of chloroform/chlorobenzene, and another solution was prepared by dissolving 1.4 wt% of PCBNB (compound (7) below) as a fullerene derivate manufactured by Frontier Carbon in a 1 : 1 solvent mixture (weight) of chloroform/chlorobenzene. The solutions of compounds (5) and (7) were mixed at a weight ratio of 1 : 1, the mixture was filtered, and the aforementioned film of compound (6) was spin-coated with the mixture at 1,500 rpm. After that, heating was performed at 180°C for 20 min, thereby obtaining a film mixture of compounds (6) and (7).

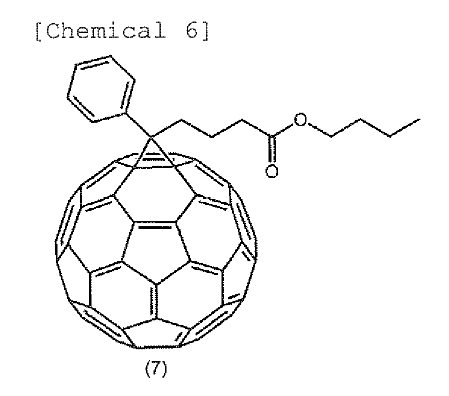

A solution prepared by dissolving 1.2 wt% of compound (7) in toluene was filtered, and the above-mentioned film mixture of compounds (6) and (7) was spin-coated with the solution at 3,000 rpm. After that, heating was performed at 65°C for 10 min, thereby obtaining a film of compound (7).

Then, the substrate on which the series of organic layers described above were deposited was set in a vacuum deposition apparatus such that the substrate was in tight contact with a 2-mm wide shadow mask in a direction perpendicular to the transparent electrode stripes. After that, lithium fluoride (LiF) was deposited on the organic layers at a deposition rate of about 0.01 nm/sec so as to have a film thickness of 0.5 nm. Subsequently, aluminum was deposited on the LiF layer at a deposition rate of 0.2 nm/sec so as to have a film thickness of 80 nm, thereby forming a metal electrode. Thus, an organic thin-film solar cell element 520 having a 2 × 2-mm light receiving area portion was obtained.

### [Making of Organic Thin-film Solar Cell Module]

### <Example E1>

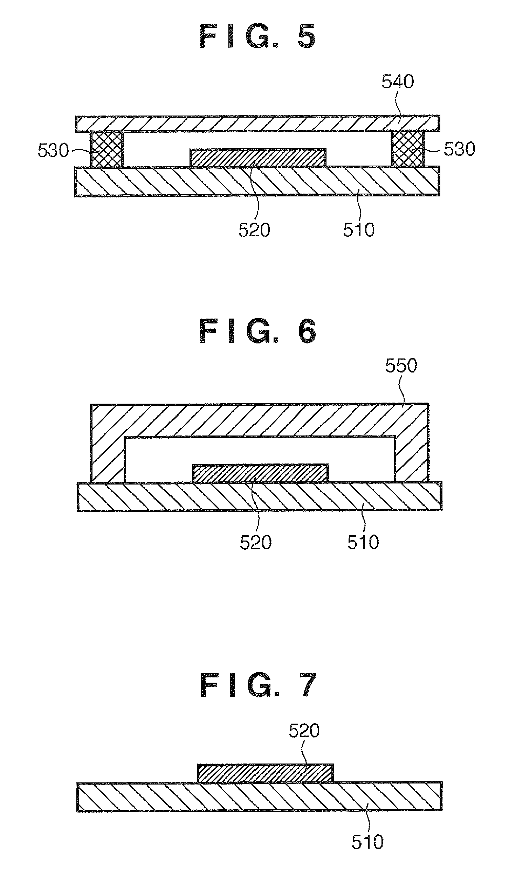

A gas barrier film 540 was adhered on a 2-mm thick glass spacer 530 on the surface of the organic thin-film solar cell element 520 formed on the glass substrate 510, thereby encapsulating the element. An organic thin-film solar cell module according to Example E1 was thus manufactured. In Example E1 the gas barrier film (the water vapor transmittance was 0.02 g/m²/day when measured by gravimetry) of Example D1 was used as the gas barrier film 540. A UV-curing resin was used to adhere the glass substrate 510 and glass spacer 530, and the glass spacer 530 and gas barrier film 540. Fig. 5 shows the arrangement of the organic thin-film solar cell module according to Example E1.

### <Example E2>

In Example E2, an organic thin-film solar cell module was manufactured following the same procedure as in Example E1 except that the following gas barrier film was used instead of the gas barrier film of Example D1. A gas barrier film 540 according to Example E2 was formed by adhering two gas barrier films of Example C10 and a biaxially stretched polyethyleneterephthalate film ("Q51C" manufactured by Teijin Du Pont, thickness = 25 µm) by using two-pack adhesives ("DYNAGRAND IS-063" and "DYNAGRAND LCR-085" manufactured by TOYO INK, thickness = 5 µm). The gas barrier film of Example C10 had a structure in which the substrate film/weather-resistant coating layer/inorganic thin film layer were laminated in this order, and the gas barrier film 540 according to Example E2 had a structure in which the substrate film/weather-resistant coating layer/inorganic thin film layer/adhesive/substrate film/weather-resistant coating layer/inorganic thin film layer/adhesive/biaxially stretched polyethylenenaphthalate film were laminated in this order. The water vapor transmission rate of the gas barrier film 540 according to Example E2 was 0.0005 g/m²/day when measured by the differential pressure method. Note that the gas barrier film 540 was placed such that the lowermost substrate film was in contact with the solar cell element 520. The arrangement of the organic thin-film solar cell module according to Example E2 is the same as that of Example E1, as shown in Fig. 5.

### <Comparative Example E1>

In Comparative Example E1, an organic thin-film solar cell element 520 was encapsulated by using 2-mm thick encapsulating glass 550 having a 1-mm deep cavity, instead of using the spacer 530 and gas barrier film 540 as in Example E1 A glass substrate 510, the organic thin-film solar cell element 520, and adhesives used for encapsulation were the same as those of Example E1. Fig. 6 shows the arrangement of the organic thin-film solar cell module according to this comparative example.

### <Comparative Example E2>

In Comparative Example E2, an organic thin-film solar cell element 520 formed on a glass substrate 510 was not encapsulated at all, and directly used as an organic thin-film solar cell module. Fig. 7 shows the arrangement of an organic thin-film solar cell device according to this comparative example.

### <Evaluation of Organic Thin-film Solar Cell Modules>

The performances of the organic thin-film solar cell modules manufactured in Examples E1 and E2 and Comparative Examples E1 and E2 were evaluated as follows. That is, the manufactured organic thin-film solar cell modules were stored in a room-temperature environment (20°C to 25°C, 30% to 40% RH) for 33 days, and the photoelectric conversion characteristic values were measured before and after the storage. More specifically, each organic thin-film solar cell module was irradiated with light at an AM of 1.5 G and an irradiation intensity of 100 mw/cm² by using a solar simulator (manufactured by BUNKOUKEIKI). The energy conversion efficiency was obtained from the obtained current-voltage curve. A relative efficiency was calculated by dividing the energy conversion efficiency after the storage in the room-temperature environment by that before the storage in the room-temperature environment. Table 7 shows the results.

[Table 7]

**Table 7**

| | Example E1 | Example E2 | Comparative Example E1 | Comparative Example E2 |
|---|---|---|---|---|
| Relative efficiency | 0.24 | 0.88 | 1.00 | 0.00 |

When using the gas barrier films as in Examples E1 and E2, it was possible to prevent the decrease in energy conversion efficiency caused by deterioration with time, when compared to the case in which no gas barrier film was used as in Comparative Example E2. In Example E2 using the gas barrier film having a lower water vapor transmission rate, the effect of suppressing the decrease in energy conversion efficiency was larger. However, even the solar cell module of Example E1 achieved the effect of preventing the decrease in energy conversion efficiency, without using any thick, heavy, and inflexible encapsulating glass.

The present invention is not limited to the above-mentioned embodiments, and various changes and modifications can be made without departing from the spirit and scope of the invention. Therefore, to apprise the public of the scope of the present invention, the following claims are appended.

This application claims the benefit of Japanese Patent Application No. 2009-178298, filed July 30, 2009, which is hereby incorporated by reference herein in its entirety.

## Claims

1. A solar cell module comprising a laminate obtained by laminating a gas barrier film on a layer including at least a solar cell element, **characterized in that**
said gas barrier film is formed by laminating at least a substrate film, a weather-resistant coating layer, and an inorganic thin film layer,
said weather-resistant coating layer is made of at least one of (a) a material obtained by crosslinking modified polyvinyl alcohol, (b) a material obtained by crosslinking polycaprolactone polyol and/or a material obtained by crosslinking polycarbonate polyol, and (c) an acrylic polymer having at least one group selected from the group consisting of an UV-stabilizing group, an UV-absorbing group, and a cycloalkyl group, and
a water vapor transmission rate (WvTR) of said gas barrier film at 40°C and a relative humidity of 90% is 0 < MvTR ≤ 0.1 g/m²/day.

2. A solar cell module comprising a laminate obtained by laminating a gas barrier film including at least a substrate film, a weather-resistant coating layer, and an inorganic thin film layer, on a layer including at least a solar cell element, **characterized in that**
said solar cell module is obtained by laminating said solar cell element, said substrate film, said weather-resistant coating layer, and said inorganic thin film layer in this order, and
said weather-resistant coating layer is made of at least one of (a) a material obtained by crosslinking modified polyvinyl alcohol, (b) a material obtained by crosslinking polycaprolactone polyol and/or a material obtained by crosslinking polycarbonate polyol, and (c) an acrylic polymer having at least one group selected from the group consisting of an UV-stabilizing group, an UV-absorbing group, and a cycloalkyl group.

3. The solar cell module according to claim 1 or 2, **characterized in that** said acrylic copolymer having at least one group selected from the group consisting of an UV-stabilizing group, an UV-absorbing group, and a cycloalkyl group is obtained by reacting an acrylic copolymer having a hydroxyl group and at least one group selected from the group consisting of a hindered amine group, a benzotriazole group, a benzophenone group, and a cycloalkyl group, with an isocyanate compound and/or an epoxy compound.

4. The solar cell module according to any one of claims 1 to 3, **characterized in that** a thickness of said weather-resistant coating layer is 0.005 to 5 µm.

5. The solar cell module according to any one of claims 1 to 4, **characterized in that** said solar cell element is a thin-film solar cell element.

6. The solar cell module according to any one of claims 1 to 5, **characterized in that** a thickness of said solar cell element is not more than 100 µm.

7. The solar cell module according to any one of claims 1 to 6, **characterized in that** said solar cell element contains a CIGS semiconductor.

8. The solar cell module according to any one of claims 1 to 6, **characterized in that** said solar cell element contains an organic semiconductor.

9. The solar cell module according to any one of claims 1 to 8, **characterized in that** said substrate film contains polyethylenenaphthalate.

10. The solar cell module according to any one of claims 1 to 9, **characterized in that** said inorganic thin film layer comprises at least two thin inorganic films.

11. The solar cell module according to any one of claims 1 to 10, **characterized in that** a power generation efficiency after exposure to air at a temperature of 85°C and a humidity of 85% for 155 hrs is higher than that before the exposure.
